(19) Europäisches Patentamt

European Patent Office

Office européen des brevets

(11) **EP 2 378 308 A1**

(12) **EUROPÄISCHE PATENTANMELDUNG**

(43) Veröffentlichungstag:
**19.10.2011 Patentblatt 2011/42**

(51) Int Cl.:
***G01R 33/54*** *(2006.01)*

(21) Anmeldenummer: **11160414.6**

(22) Anmeldetag: **30.03.2011**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **31.03.2010 DE 102010003552**

(71) Anmelder: **Universitätsklinikum Freiburg**
**78106 Freiburg (DE)**

(72) Erfinder:
• **Weber, Hans**
**79106 Freiburg (DE)**

• **Zaitsev, Maxim**
**79117 Freiburg (DE)**
• **Gallichan, Daniel**
**79110 Freiburg (DE)**
• **Schultz, Gerrit**
**76199 Karlsruhe (DE)**

(74) Vertreter: **Kohler Schmid Möbus**
**Patentanwälte**
**Ruppmannstraße 27**
**70565 Stuttgart (DE)**

(54) **Verfahren zur Homogenisierung der Auflösung in Magnetresonanz-Tomographie-Aufnahmen unter Verwendung von nicht-linearen Kodierfeldern**

(57) Ein Verfahren der bildgebenden Magnetresonanz (=MR), wobei zur Aufnahme von Bildern eines abzubildenden Objekts zum Zwecke der Ortskodierung nicht-lineare Gradientenfelder angelegt werden und wobei das von dem abzubildenden Objekt ausgestrahlte Magnetresonanzsignal auf Rastern im k-Raum abgetastet wird, wodurch Abtastpunkte erhalten werden, ist dadurch gekennzeichnet, dass das abzubildende Objekt in Bereichen stärkerer Gradientenfelder durch Erhöhung der Dichte der Abtastpunkte in der Mitte des k-Raums vollständig abgebildet wird, dass abhängig von der gewünschten Verteilung der Auflösung in der Aufnahme gezielt nach einem k-Raum-Abtastmuster zusätzliche Abtastpunkte in den äußeren Bereichen des k-Raums aufgenommen werden, und dass die MR-Aufnahme mit den zusätzlichen Abtastpunkten berechnet wird.

Damit wird ein bildgebendes MR-Verfahren zur Verfügung gestellt, bei dem unter Verwendung von nicht-linearen Gradientenfeldern zur Ortskodierung eine homogenisiertere Auflösung in den MR-Aufnahmen erreicht wird.

Fig. 7

EP 2 378 308 A1

# EP 2 378 308 A1

**Beschreibung**

Die Erfindung betrifft ein Verfahren der bildgebenden Magnetresonanz (=MR), wobei zur Aufnahme von Bildern eines abzubildenden Objekts zum Zwecke der mindestens zweidimensionalen Ortskodierung nicht-lineare Gradientenfelder angelegt werden und wobei das von dem abzubildenden Objekt ausgestrahlte Magnetresonanzsignal auf Rastern im Zeitraum abgetastet wird, wodurch Abtastpunkte erhalten werden.

Ein solches Verfahren ist etwa aus DE 10 2007 054 744 B4 und DE 10 2005 051 021 A1 bekannt.

Kernspinresonanz (=NMR)-Tomographie, auch als bildgebende Magnetresonanz (=MRI), MR-Bildgebung oder Magnetresonanztomographie (=MRT) bezeichnet, ist ein nicht-invasives Verfahren, welches es ermöglicht, die innere Struktur von Objekten räumlich dreidimensional aufzulösen und darzustellen. Sie basiert auf dem energetischen Verhalten von Atomkernen in einem Magnetfeld, welches eine Anregung ihrer Kernspins durch geeignete Hochfrequenzpulse und eine anschließende Analyse der Reaktion erlaubt. Anwendung findet die bildgebende MRT vor allem in der Medizin, um Einblicke in das Innere eines menschlichen Körpers zu erhalten.

Das als Reaktion auf die Anregung mit Hochfrequenzpulsen ausgesendete Signal der Atomkerne des zu untersuchenden Objektes wird mit geeigneten Empfangsspulen ausgelesen. Die notwendige Ortskodierung, um das Messsignal einem Ort innerhalb des abzubildenden Objektes zuordnen zu können, erfolgt über zusätzliche, räumlich veränderliche, Magnetfelder $B_z(x,y,z)$, welche dem statischen Hauptmagnetfeld $B_0$ überlagert werden und somit bewirken, dass Atomkerne an unterschiedlichen Orten unterschiedliche Larmorfrequenzen aufweisen. Konventionell werden hier Magnetfelder mit einer möglichst linearen Änderung der Stärke entlang der jeweiligen Raumrichtung verwendet, sogenannte konstante, beziehungsweise lineare Magnetfeldgradienten. Übliche Gradientensystem erzeugen hierbei drei orthogonale Gradienten in x-, y- und z-Richtung, jedoch finden auch lokale Gradientensysteme in der Ortskodierung Verwendung. Die 1-, 2- oder 3-dimensionale Ortskodierung erfolgt unter Variation der Magnetfeldgradienten in allen drei Raumrichtungen entsprechend den bekannten Prinzipien, etwa der Fourierkodierung, der gefilterten Rückprojektion oder einem anderen bekannten Verfahren [1]. Die auf Grund dieser Variation in der Gegenwart von unterschiedlich starken Gradienten gemessenen MR-Signale S werden im k-Raum gespeichert, wobei sich die Position im k-Raum aus der Stärke und der Dauer der geschalteten Gradientenfelder ergibt. Weiche k-Raum-Punkte in welcher Reihenfolge während einer Aufnahme abgetastet werden, wird durch die jeweilige Trajektorie des Aufnahmeverfahrens beschrieben. Allgemein werden zur Mitte des k-Raums hin die Signalanteile gespeichert, weiche die niederfrequenten Informationen enthalten und somit die grobe Struktur des abzubildenden Objektes beschreiben. Im Gegenzug dazu enthalten die Randbereiche die hochfrequenteren Detailinformationen.

Allgemein lässt sich die Signalintensität im k-Raum $S(k_x, k_y, k_z)$ durch Anwendung der Kodiermatrix E auf die Signaldichte des abzubildenden Objektes im Ortsraum $I_r(x,y,z)$ beschreiben:

$$(1) \quad S = E\, I_r$$

Somit ist es möglich, durch Inversion der Kodiermatrix und Anwendung dieser auf die aufgenommenen k-Raum-Daten, die Signaldichte und somit das zu rekonstruierende Bild(=MR-Aufnahme) direkt zu berechnen. Im gewöhnlichen Fall eines äquidistant abgetasteten k-Raumes vereinfacht sich dieser Rekonstruktionsprozess: die Signaldichte im Frequenzraum $(I_\omega, (\omega_x, \omega_y, \omega_z))$ ergibt sich direkt aus der inversen Fouriertransformierten (iFT) des k-Raum-Signales $S(k_x, k_y, k_z)$:

$$(2) \quad I_\omega = \mathrm{iFT}(S)$$

Entsprechend des Verlaufes der Magnetfeldgradienten lässt sich diese in die Signaldichte im Ortsraum $I_r(x,y,z)$ transformieren. Bei der Ortskodierung mit konventionellen linearen Gradienten ergibt sich hier eine lineare Beziehung zwischen Frequenz- und Ortsraum, die Auflösung im rekonstruierten Bild ist folglich räumlich homogen. Auf Grund der diskreten Abtastung des k-Raumes stellt das rekonstruierte Bild eine Überlagerung unendlicher Wiederholungen des abzubildenden Objektes dar. Der Abstand der Wiederholungen im Bildraum ist gemäß

**2**

$$(3) \ FOV = \frac{1}{\Delta k}$$

durch den Abstand $\Delta k$ der Punkte im k-Raum gegeben. Der Abstand FOV (=Field of View) wird allgemein auch als Sichtfeld bezeichnet und ist gemäß Gleichung (3) reziprok zum Abstand der k-Raum-Punkte. Eine Vergrößerung des Abstands $\Delta k$ beim Abtasten des k-Raums führt folglich zu einer Verkleinerung des FOV. Bei einem zu kleinem FOV, welches das abzubildende Objekt nicht vollständig abdeckt, überlagern sich die Wiederholungen. Die außenliegenden Bereiche des abzubildenden Objektes erscheinen daher in der rekonstruierten MR-Aufnahme als nach innen gefaltet. Diese gefalteten Bildanteile werden als Aliasing bezeichnet. Werden nun N k-Raum-Punkte mit Abstand $\Delta k$ aufgenommen, so entspricht dies einer maximalen k-Raum-Deckung von N $\times$ $\Delta k$. Gemäß dem Nyquist-Theorem

$$(4) \ N \times \Delta k = \frac{N}{FOV} = \frac{1}{\Delta x}$$

ergibt sich hieraus die Bildauflösung $\Delta x$. Die Anzahl der Bildpunkte innerhalb des FOV, weiche auch als Voxel bezeichnet werden, entspricht somit der Anzahl der aufgenommenen k-Raum-Punkte.

Für eine eindimensionale Aufnahme wird eine Zeile im k-Raum aufgenommen. Der während der Aufnahme geschaltete Gradient wird als Lesegradient bezeichnet. Die Auflösung der MR-Aufnahmen ist durch die Stärke und Dauer des Lesegradienten bestimmt: je steiler der Gradient und je länger er geschaltet ist, desto weiter von der k-Raum-Mitte entfernte Punkte können aufgezeichnet werden. Für zweidimensionale MR-Aufnahmen werden mehrere k-Raum-Zeilen aufgenommen, wobei die Anzahl der Zeilen der Anzahl an Punkten in der zweiten Bilddimension entspricht. Der für die sogenannte Phasenkodierung zuständige Gradient wird hierbei für ein bestimmtes Zeitintervall zwischen der Anregung und der Aufnahme des Signals geschalten, wobei seine Stärke für jede Zeile entsprechend variiert wird. Die Aufnahmedauer ergibt sich folglich aus dem Produkt der Anzahl an Zeilen und der Dauer TR (= Time of Repetition) für die Aufnahme einer Zeile. Im Falle dreidimensionaler MR-Aufnahmen wird der k-Raum um eine dritte Dimension erweitert, für die Kodierung wird ein zusätzlicher Phasengradient entlang der entsprechenden Richtung geschaltet. Die Anzahl der k-Raum-Punkte entlang derjeweiligen Dimension und dementsprechend auch die Anzahl der resultierenden Bildpunkte werden durch die sogenannte Matrixgröße beschrieben. Für eine Matrixgröße von $N_x \times N_y \times N_z$ und einer Zeilenaufnahmedauer TR ergibt sich für eine 3D Aufnahme folglich eine Messzeit TA (= Time of Acquisition) von

$$(5) \ TA(3D) = \ N_y \times N_z \times TR,$$

für eine 2D Aufnahme mit $N_x \times N_y$ Matrix entsprechend

$$(6) \ TA(2D) = \ N_y \times TR.$$

Um die Messzeit zu reduzieren, erfordern moderne mehrdimensionale MR Verfahren starke Gradienten von kurzer Dauer, sowie eine schnelle Schaltung dieser.

Eine weitere Möglichkeit die Aufnahmedauer zu reduzieren ist durch die Verwendung mehrerer Empfangsspulen und der damit verbundenen Ortsinformationen gegeben [2]. Bei der parallelen Bildgebungstechnik SENSE [3], bekannt aus US 6,326,786 B1, werden während der Aufnahme k-Raum-Zeilen gezielt ausgelassen. Die Aufnahmedauer wird dadurch verkürzt, man spricht hier von einer Beschleunigung. Die aus den aufgenommenen Daten der einzelnen Spulen rekonstruierten Bilder sind folglich jedoch gefaltet. Auf Grund der räumlich unterschiedlich variierenden Sensitivität der einzelnen Empfangsspulen, mit welcher das empfangene Signal jeweils moduliert wird, kommt es in jedem Spulenbild zu einer unterschiedlichen Gewichtung zwischen der Intensität des Bildes und der des Aliasing. Sind die Sensitivitätsverteilungen der einzelnen Spulen bekannt, kann das Aliasing durch Lösung eines entsprechenden Gleichungssystems beschrieben und dementsprechend aus dem aus allen Spulendaten resultierenden Gesamtbild herausgerechnet werden. Eine weitere parallele Bildgebungstechnik ist als GRAPPA [4] bekannt aus DE 101 26 078 B4. Im Gegensatz zu SENSE werden hier aus den zusätzlichen Spuleninformationen die fehlenden k-Raum-Zeilen vor der Rekonstruktion der MR-Aufnahme berechnet.

Mit der fortschreitenden technischen Entwicklung ist es in der Geschichte der MR-Bildgebung gelungen, immer stärkere Gradienten zu bauen und somit höhere Auflösungen in den Bildern zu erzielen. Allein bedingt durch die technische Tatsache, dass Zuleitungen und Spulendrähte aus räumlichen Gründen nicht mehr weiter verstärkt werden können, stellen noch stärkeren Gradientensystem keine Zukunftsiösung dar. Zudem erzielen bereits gängige lineare Gradientensysteme vor allem bei größeren abzubildenden Objekten und typischen Ortsauflösungen und Messzeiten erhebliche Magnetfeldunterschiede in den Randbereichen. Diese wechselwirken mit dem Hauptmagnetfeld $B_0$, die daraus resultierenden, schnell veränderlichen Lorentzkräfte führen zu einer starken mechanischen Beanspruchung im Tomographen, verbunden mit einer erheblichen Lärmbelastung. Bei Patienten können diese schnellen und starken Feldvariationen zusätzlich zu neurologischen Stimulationen führen. Das technische Limit hat somit auch das physiologische Limit des Menschen erreicht. Eine weitere Erhöhung der Auflösung, beziehungsweise Reduzierung der Messzeit erfordert daher alternative Ansätze. Ein solcher Ansatz hierfür sind Systeme, welche angepasste, nicht lineare Gradienten zur Ortskodierung verwenden, wie zum Beispiel PatLoc [5] (bekannt aus DE 10 2007 054 744 B4 und DE 10 2005 051 021 A1). In einer typischen Implementierung werden zum Beispiel für die Kodierung in x und y Richtung quadrupolare Felder verwendet, die Kodierung entlang der Richtung des $B_0$ Feldes erfolgt aus technischen Gründen weiterhin mit einem linearen Gradienten. Diese nicht linearen Gradientensysteme zeichnen sich durch geringere Magnetfeldunterschiede im abzubildenden Bereich aus, so dass schnellere Schaltzeiten der Gradienten möglich sind. Für die Transformation zwischen Frequenz- und Ortsraum ergibt sich entsprechend eine nichtlineare Abbildungsgleichung.

Nachteilig an diesem Stand der Technik ist es jedoch, dass die Verwendung von nicht linearen Gradientenfeldern zur Ortskodierung eine räumlich inhomogene Auflösung in den resultierenden Bildern zur Folge hat. Gerade in der medizinischen Diagnostik erschwert dies die Interpretation der MR-Aufnahmen erheblich. Bereiche mit flachem Gradientenprofil werden nur durch wenige und dementsprechend große Voxel dargestellt. Extrem flache Stellen resultieren in einem einzigen Voxel und erscheinen daher als "Löcher" in den Bildern. Eine Darstellung des abzubildenden Objektes ist hier folglich gar nicht möglich. Eine Erhöhung der Auflösung in den niedriger aufgelösten Bereichen und somit schrittweise Reduzierung des "Lochdurchmessers" ist bisher nur durch das Standardverfahren einer zeitintensiven globalen Anhebung der Auflösung in der gesamten MR-Aufnahme möglich.

Bei dem Standardverfahren der globalen Auflösungserhöhung werden zudem zwangsläufig Teile der zusätzlichen Messzeit nur darauf verwendet, auch in den Bereichen mit steilerem Gradientenprofil, und demnach mit bereits ausreichender Auflösung, letztere weiter zu erhöhen. Vor allem im Sinne einer Messzeitreduktion ist solch eine zeitaufwendige Auflösung des Objektes über die Anforderungen hinaus nicht förderlich. Wird in den Bereichen hoher Gradientenstärke auch noch das durch die Moleküldiffusion gegebene physikalische Auflösungslimit einer MR-Messung erreicht, ist zudem gar kein Informationszugewinn mehr möglich. Aber auch bei niedriger aufgelösten Bereichen ist der zusätzliche Informationsgewinn bereits beschränkt, da sich kleinere Voxel durch ein geringeres Signal-zu-Rausch (= SNR) Verhältnis auszeichnen. Durch eine Erhöhung der Auflösung über die Anforderungen hinaus wird somit auch die Bildqualität verschlechtert.

Aufgabe der Erfindung

Der Erfindung liegt daher die Aufgabe zugrunde, ein bildgebendes MR-Verfahren zur Verfügung zu stellen, bei dem unter Verwendung von nicht-linearen Gradientenfeldern zur Ortskodierung eine homogenisiertere Auflösung in den MR-Aufnahmen erreicht wird.

Kurze Beschreibung der Erfindung

Diese Aufgabe wird erfindungsgemäß auf überraschend einfache wie wirkungsvolle Weise dadurch gelöst, dass das abzubildende Objekt in Bereichen stärkerer Gradientenfelder durch Erhöhung der Dichte der Abtastpunkte in der Mitte des k-Raums ausreichend genau abgebildet wird, dass abhängig von der gewünschten Verteilung der Auflösung in der Aufnahme gezielt gemäß einem k-Raum-Abtastmuster zusätzliche Abtastpunkte in den äußeren Bereichen des k-Raums aufgenommen werden, und dass die MR-Aufnahme mit den zusätzlichen Abtastpunkten berechnet wird.

Die Erfindung beruht auf dem Prinzip, dass durch gezielte, lokale Erhöhung der Auflösung in den, auf Grund schwächerer Gradienten, niedriger aufgelösten Bereichen die Auflösung an das Niveau der Auflösung in den bereits ausreichend aufgelösten Bereichen angepasst wird.

Die mit der Erfindung erzielten Vorteile bestehen insbesondere darin, dass durch die gezielte Anpassung der Auflösung in den schlechter aufgelösten Bereichen an das Niveau der Auflösung in den bereits ausreichend höher aufgelösten Bereichen, die Gesamtauflösung innerhalb des MR-Aufnahme homogenisiert wird. Somit ist es möglich, alle Strukturen des abzubildenden Objektes innerhalb des abgebildeten Bereiches mit vergleichbarer Genauigkeit darzustellen. In den Bereichen sehr niedriger Gradienten, wie zum Beispiel im Bereich des Nulldurchganges bei einem quadrupolaren Feld, wird die Größe des Voxels, in welchem gar keine Darstellung stattfindet, durch die lokale Auflösungserhöhung verkleinert. Die Interpretation der MR-Aufnahmen wird dadurch enorm erleichtert. Eine gleichmäßige Auflösung entspricht zudem dem Stand konventioneller MR-Aufnahmen, in deren Interpretation die Nutzer bereits geübt sind.

Prinzipiell gemeint ist, dass die Dichte der Abtastpunkte (definiert über den Abstand der Abtastpunkte) so gewählt wird, so dass das resultierende Sichtfeld das abzubildende Objekt ausreichend abdeckt und dass die resultierende Auflösung (bedingt durch die Anzahl und den Abstand der Abtastpunkte) in den Ortsbereichen der stärkeren Gradientenfelder so hoch ist, dass dort das abzubildende Objekt ausreichend genau, d. h. den Zielauflösungsvorstellungen entsprechend, abgebildet wird.

Bei dem erfindungsgemäßen Verfahren wird die Mitte des k-Raums mit einer höheren Dichte abgetastet, so dass das abzubildende Objekt in den Bereichen stärkerer Gradientenfelder ausreichend abgebildet wird, sowie dass gezielt zusätzliche Punkte in den äußeren Bereichen des k-Raumes aufgenommen werden um mit den damit verbundenen hochfrequenteren Informationen den Informationsgehalt der MR-Aufnahmen in den niedriger aufgelösten Bereichen zu erhöhen. Ermöglicht wird dies durch die Eigenschaft, dass unter Verwendung nicht linearer Gradienten zur Ortskodierung eine Korrelation zwischen Ortsraumposition und k-Raum-Position gegeben ist. Die Aufnahme niederfrequenterer k-Raum-Signale durch Abtastung der k-Raum-Mitte mit hoher Dichte reicht somit bereits aus, das abzubildende Objekt in den Bereichen mit steilerem Gradientenprofil ausreichend aufgelöst darstellen zu können. Der Abstand der aufgenommenen Punkte im k-Raum legt auch hier die Größe des Sichtfeldes fest und ist entsprechend klein gewählt, so dass das gesamte Objekt abgedeckt wird. Analog zu Gleichung 4 erfordert eine Erhöhung der Bildauflösung die zusätzliche Aufnahme hochfrequenterer k-Raum-Punkte. Wird hierbei der Abstand der zusätzlichen k-Raum-Punkte erhöht, so tragen diese Punkte nur zur Erhöhung der Auflösung in einem entsprechend kleinerem Sichtfeld bei. Dieser Prozess ist vergleichbar mit einer Reduzierung des Sichtfeldes durch Erhöhung der k-Raum-Schrittweite. Durch gezielte Wahl der Position der zusätzlichen k-Raum-Punkte und entsprechender Ausrichtung des zugehörigen Sichtfeldes kann die damit verbundene Auflösungserhöhung auf die Bereiche mit schwächerem Gradientenprofil und dementsprechend schlechterer Auflösung begrenzt werden. Auch in diesem Fall hat eine Verkleinerung des Sichtfeldes bei Nichtabdeckung des zu untersuchenden Objektes Faltungsartefakte zur Folge. Auf Grund der vorliegenden Korrelation zwischen k-Raum und Ortsraum sind die nun nach innen gefalteten Büdanteile jedoch bereits aus den niederfrequenteren k-Raum-Daten ausreichend genau bekannt und erlauben somit die Eliminierung der entsprechenden Artefakte in den Bereichen mit gesteigerter Auflösung. Somit wird gegenüber dem Standardverfahren der globalen Auflösungserhöhung eine Reduzierung der Messzeit erreicht, da nur die k-Raum-Punkte aufgenommen werden, welche auch tatsächlich zur Erhöhung der Auflösung in den niedriger aufgelösten Bereichen beitragen.

Bevorzugte Varianten der Erfindung

Bei einer Variante des erfindungsgemäßen Verfahrens setzt sich das k-Raum-Abtastmuster aus Untermustern zusammen, wobei jedes Untermuster aus der gleichen Anzahl von Abtastpunkten besteht, wobei für jedes Untermuster die Schrittweite zwischen den Abtastpunkten mit einem flexiblen Faktor gemäß den Anforderungen an die Homogenität der Auflösung der MR-Aufnahme und an die Signal-zu-Rausch(=SIVR)-Verteilung in der Aufnahme erhöht wird. Die k-Raum-Daten jedes Untermusters i entsprechen hierbei einem Sichtfeld $FOV_i$ mit einer aus der jeweiligen k-Raum-Abtastschrittweite resultierenden Auflösung. Die Größe des Sichtfeldes des Untermusters mit maximaler Schrittweite ($\Delta k_1$) ergibt wiederum der Größe des Gesamtsichtfeldes. Somit wird durch sukzessive Hinzunahme weiterer k-Raum-Punkte gemäß den Untermustern, die Auflösung in den zuvor niedriger aufgelösten Bereichen schrittweise erhöht. Über den Abstandsfaktor $\alpha$, welche die Zunahme der Schrittweite bestimmt, ist eine gezielte Wahl der Größe der Unterbereiche $FOV_i$, in denen die Auflösung jeweils um einen konstanten Faktor gegenüber der Auflösung im angrenzenden Unterbereich erhöht ist, möglich. Der Abstand zwischen den Unterbereichen kann somit individuell angepasst werden. Gegenüber dem Standardverfahren der globalen Auflösungserhöhung wird auf Grund der Reduzierung der insgesamt aufzunehmenden Datenpunkte eine Zeitersparnis bei der Datenaufnahme erzielt.

Eine andere bevorzugte Verwendungsvariante ist dadurch gekennzeichnet, dass sich das k-Raum-Abtastmuster aus Untermustern zusammensetzt, wobei für jedes Untermuster die Schrittweite zwischen den Abtastpunkten verdoppelt wird und die Anzahl an Abtastpunkten pro Untermuster gemäß den Anforderungen an die Homogenität der Auflösung der MR-Aufnahme und an die Signal-zu-Rausch(=SNR)-Verteilung in der Aufnahme variiert wird. Somit wird durch eine sukzessive Hinzunahme weiterer k-Raum-Punkte gemäß den Untermustern die Auflösung in den zuvor niedriger aufgelösten Bereichen ebenfalls schrittweise erhöht. Über die Anzahl an aufgenommenen k-Raum-Punkten pro Untermuster kann nun die Auflösungserhöhung innerhalb eines Unterbereiches gegenüber dem angrenzenden Unterbereichen individuell angepasst werden. Dies erlaubt es insbesonders, den Sprung der Auflösungen am Übergang zwischen zwei Unterbereichen anzupassen.

Im Rahmen der vorliegenden Erfindung fällt auch eine Verwendungsvariante, die dadurch gekennzeichnet ist, dass sich das k-Raum-Abtastmuster aus Untermustern zusammensetzt, wobei für jedes Untermuster die Schrittweite zwischen den Abtastpunkten mit einem flexiblen Faktor gemäß den Anforderungen an die Homogenität der Auflösung der MR-Aufnahme und an die Signal-zu-Rausch(=SNR)-Verteilung in der Aufnahme geändert wird, sowie die Anzahl an Abtastpunkten pro Untermuster gemäß den Anforderungen an die Homogenität der Auflösung der MR-Aufnahme und an die Signal-zu-Rausch(=SNR)-Verteilung in der Aufnahme variiert wird, wobei für die gegebene Gradientenfeldgeometrie die Schrittweite des Untermusters mit kleinstem Punkteabstand die Größe des Gesamtsichtfeldes bestimmt, und wobei für die gegebene Gradientenfeldgeometrie die Schrittweite und die Anzahl der Abtastpunkte des Untermusters mit dem größten Punkteabstand die Größe des größten Voxels bestimmen. So kann auch ein k-Raum-Abtastmuster mit einer besonders glatt und monoton abfallender Abtastdichte approximiert werden. Diese Verwendungsvariante erlaubt die Erzeugung einer Vielzahl von k-Raum-Abtastmustern aus kartesischen Untermustern. Ebenfalls ermöglicht es diese Verwendungsvariante über den Verlauf der Abtastdichte die Größe der Unterbereiche, sowie den Grad der Auflösungserhöhung in diesen, an die vorhandene Geometrie des Gradientenfeldes und des abzubildenden Objektes anzupassen.

Bei einer anderen bevorzugten Verwendungsvariante entspricht das k-Raum-Abtastmuster einer radialen Abtastung des k-Raumes, wobei die Abtastdichte mit dem Abstand zur k-Raum-Mitte glatt und monoton abfällt, wobei die absolute Abtastdichte global über die Anzahl der abgetasteten k-Raum-Strahlen skaliert wird, wobei für die gegebene Gradientenfeldgeometrie die Größe des größten Voxels durch die Länge der k-Raum-Strahlen und durch den maximalen Abstand der k-Raum-Strahlen am Rande des abgetasteten k-Raumes bestimmt wird. Die einhergehende Unterabtastung erfolgt hierbei automatisch in beiden Dimensionen des k-Raums. Auf Grund der zunehmenden Abtastdichte zur Mitte des k-Raums hin, ist zudem eine Interpolation der Daten auf kartesische Untermuster mit homogenem Punkteabstand entsprechend der minimalen Dichte im ursprünglichen Muster möglich.

Alternativ sieht eine andere Verwendungsvariante vor, dass das k-Raum-Abtastmuster einer spiralförmigen Abtastung des k-Raumes entspricht, wobei die Spirale aus einem oder mehreren Elementen besteht, wobei die absolute Abtastdichte global über die Anzahl der Spiralelemente und lokal über die Änderung der Spiralenradiensteigung variiert wird, wobei für die gegebenen Gradientenfeldgeometrie der maximale radiale Punkteabstand im Bereich der Mitte des k-Raumes die Größe des Gesamtsichtfeldes bestimmt, wobei für die gegebene Gradientenfefdgeomefirie die maximale Entfernung der Abtastpunkte von der Mitte des k-Raumes und der maximale radiale Punkteabstand im Randbereich des abgetasteten k-Raumes die Größe des größten Voxels bestimmen. Die radiale Abtastung stellt somit ein besonders flexibles k-Raum-Abtastschema dar. Im Gegensatz zur radialen Abtastung ist es über die Anzahl der Spiralelemente und die Änderung der Spiralenradiensteigungen ebenfalls möglich, die Abtastdichte in der Mitte des k-Raumes und den Abfall der k-Raum-Abtastdichte gezielt zu ändern. Im Falle eines ausreichend langsamen Signalabfalls kann zudem bei Anlegung des Lesegradienten entlang der Spirale mittels weniger bis hin zu nur einer Anregung der k-Raum vollständig abgetastet werden. Ebenfalls erfolgt die Unterabtastung automatisch in beiden Dimensionen des k-Raums.

Eine andere vorteilhafte Weiterentwicklung sieht vor, dass die Datenaufnahme mit einem Array bestehend aus mehreren Empfangsspulen erfolgt, wobei die räumliche Information, welche in der unterschiedlichen Sensitivitätsverteilung der Empfangsspulen enthalten ist, verwendet wird, die Unterabtastung des k-Raums zu erhöhen. Die Empfangs-spulen sind hierbei um das abzubildende Objekt herum angeordnet. Die hieraus resultierende zusätzliche Ortskodierung der aufgenommenen Signale kann nun ebenfalls zur Eliminierung der während des Homogenierungsprozesses auftretenden Faltungsartefakte verwendet werden. Durch die Verwendung mehrer Empfangsspulen ist es somit möglich, die Anzahl an aufzunehmenden k-Raum-Daten zu reduzieren, beziehungsweise die Abstandsfaktoren $\alpha_i$ weiter zu erhöhen. Die Datenaufnahme wird dadurch signifikant beschleunigt.

Bei einer Weiterentwicklung dieser Verwendungsvariante erfolgt die Rekonstruktion der Signaldichte des darzustellenden Objektes durch Inversion der Kodiermatrix aus den aufgenommenen Daten. Hierbei finden die bekannten Verfahren der Matrixinversion Anwendung, die resultierende Auflösung kann bei diesem Verfahren stark durch die Art des Inversionsprozesses bestimmt werden. Somit ist die direkte Rekonstruktion von k-Raum-Daten ohne besondere Anforderungen an das Abtastschema, unter Voraussetzung der Verfügbarkeit entsprechender Rechnerleistung, möglich. Es können folglich die MR-Aufnahmen aus k-Raum-Daten berechnet werden, welche mit beliebigen Abtastmustern aufgenommen wurden. Da somit eine Interpolation der k-Raum-Punkte auf ein äquidistantes Gitter oder Ähnliches nicht notwendig ist, entfällt die entsprechende Verfälschung der k-Raum Daten. Dies ist besonders von Vorteil im Falle maßgeschneiderter Abtastmuster, bei denen gezielt und effizient die notwendigen k-Raum Punkte aufgenommen werden und eine direkte Anwendung standardisierter Fourier-Methoden in der Rekonstruktion nicht möglich ist.

Alternativ sieht eine andere Verwendungsvariante vor, dass die Signaldichte des darzustellenden Objektes iterativ mit der Methode der konjugierten Gradienten über das Produkt aus der inversen Kodiermatrix und der Signalintensität im k-Raum angenähert wird. Diese Verwendungsvariante erlaubt somit ebenfalls die direkte Rekonstruktion der k-Raum-Daten ohne besondere Anforderungen an das Abtastschema. Im Gegensatz zur Methode der Matrixinversion benötigt sich jedoch vor allem bei größeren Datensätzen signifikant weniger Rechnerleistung und Rechenzeit.

Eine andere bevorzugte Verwendungsvariante ist dadurch gekennzeichnet, dass die k-Raum-Punkte entsprechend den jeweiligen Untermustern getrennt mit schnellen, standardisierten Fourier-Methoden rekonstruiert werden und das auflösungshomogenisierte Bild aus den Einzelbildern der Untermuster iterativ berechnet wird. Dieses Verfahren wird im Folgenden als "Iterationsverfahren" bezeichnet. Die jeweils höher aufgelösten Einzelbilder aus den k-Raum-Daten der jeweiligen Untermuster ersetzen hierbei die entsprechenden Bereiche in den niedriger aufgelösten Einzelbildern. Um die Faltungsanteile in den höher aufgelösten Einzeibildern eliminieren zu können, wird die Faltung aus den jeweils eine Stufe niedriger aufgelösten Einzelbildern simuliert. Dies wird auf Grund der inhomogenen Auflösung der Einzelbüder, resultierend aus der Verwendung nicht-linearer Gradienten zur Ortskodierung, mit ausreichend Genauigkeit erreicht. Der Rekonstruktionsprozess ist hierbei iterativ, beginnend bei dem am höchsten aufgelösten Einzelbild entsprechend mit der vielfachsten Faltung. Diese bevorzugte Verwendungsvariante erlaubt die Verwendung standardisierter Fourier-Methoden wie FFT innerhalb der iterativen Rekonstruktion und somit eine schnelle Büdberechnung. Da das Verfahren im Frequenzraum angewandt wird, ist nur zum Abschluss einmalig eine zeitaufwendigere Transformation in den Ortsraum notwendig. Das iterativ berechnete Gesamtbild ergibt eine Darstellung des abzubildenden Objektes mit besonders homogener Auflösung. Auch nach mehreren Iterationsschritten weisen die nun höher aufgelösten Bildbereiche eine hohe Qualität auf.

Alternativ sieht eine andere bevorzugte Verwendungsvariante vor, dass das auflösungshomogenisierte Bild aus Unterbildern zusammengesetzt wird, wobei die Unterbilder unter Verwendung von standardisierten Fourier-Methoden aus allen aufgenommenen Datenpunkten rekonstruiert werden, wobei diese hierfür auf ein äquidistantes Gitter verteilt werden und mit für das jeweilige Untermuster spezifischen Gewichtungsfaktoren gewichtet werden. Dieses Verfahren wird im Folgenden als "Gewichtungsverfahren" bezeichnet. Aus jedem Untermuster erhält man somit ein Bild mit einer dem Gesamtsichtfeld entsprechenden Größe, wobei nur der Teil des abzubildenden Objektes, weiche innerhalb eines Bereiches entsprechend dem Sichtfeld $FOV_i$ des zugehörigen Untermusters liegt, faltungsfrei dargestellt wird. Das Gesamtbild wird daher im Frequenzraum aus diesen Unterbildern zusammengesetzt und muss anschließend nur einmalig in den Ortsraum transformier werden. Diese bevorzugte Verwendungsvariante erlaubt ebenfalls die Verwendung standardisierter Fourier-Methoden innerhalb der Rekonstruktion und somit eine schnelle Berechnung der Aufnahmen. Das aus den einzelnen $FOV_i$ zusammengesetzte Bild weist eine besonders homogene SNR Verteilung auf, so dass die Übergänge zwischen den einzelnen $FOV_i$ kaum sichtbar sind.

Bei einer Weiterentwicklung dieser Verwendungsvariante wird die auflösungshomogenisierte MR-Aufnahme unter Einbeziehung der unterschiedlichen Sensitivitäfisverteiiungen der Empfangsspulen aus den unterabgetasteten k-Raum-Signalen der unterschiedlichen Empfangsspulen berechnet, wobei nur jeder R-te k-Raum-Punkt der k-Raum-Abtastmuster aufgenommen wird, wobei R kleiner gleich der Anzahl der verwendeten Empfangsspulen ist, wobei die Unterabtastung zur einer Reduktion der Aufnahmezeit und oder globalen Erhöhung der Auflösung verwendet wird. Mit Hilfe der bekannten SENSE, beziehungsweise GRAPPA Rekonstruktionstechnik wird das aus den nicht aufgenommenen k-Raum-Datenpunkten resultierende Aliasing mit Hilfe der unterschiedlichen Spulensensitivitätsverteilungen rückgerechnet (SENSE), beziehungsweise die fehlenden k-Raum-Punkte interpoliert (GRAPPA). Somit können gezielt Abtastpunkte innerhalb der Untermuster ausgelassen und die Aufnahmedauer folglich verkürzt werden. Des Weiteren ist es aber auch möglich, ganze Untermuster auszulassen, resultierend in einer weiteren Verkürzung der Messzeit.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren beliebigen Kombination Verwendung finden. Die gezeigten beschriebenen Ausführungsformen sind nicht als abschließende Aufzählung zu verstehen, sonder haben vielmehr beispielhaften Charakter für die Schilderung der Erfindung.

<u>Detaillierte Beschreibung der Erfindung und Zeichnung</u>

Die Erfindung ist in der Zeichnung dargestellt und wird anhand von Ausführungsbeispielen näher erläutert.
Es zeigen:

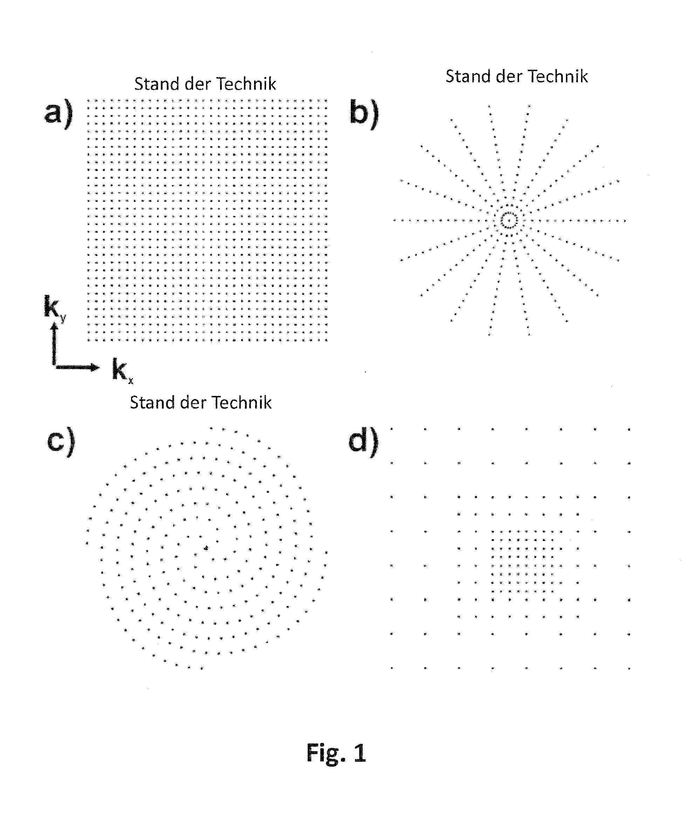

Fig. 1 a)     ein äquidistantes, kartesisches k-Raum-Abtastmuster;

Fig. 1 b)     ein radiales k-Raum-Abtastmuster;

Fig. 1 c)     ein spirales k-Raum-Abtastmuster, bestehend aus vier Spiralelementen;

Fig. 1 d)     ein kartesisches k-Raum-Abtastmuster, bestehend aus $\ell = 3$ Untermustern bei jeweiliger Verdopplung des Abtastintervalls;

Fig. 2    eine MR-Aufnahme einer Anordnung aus organischen Objekten unter Verwendung eines quadrupolaren Gradientensystems zur Ortskodierung;

Fig. 3    zwei verschiedene Verläufe der Abtastdichte pk in Abhängigkeit von der k-Raum-Position k;

Fig. 4    zwei weitere Verläufe der Abtastdichte pk in Abhängigkeit von der k-Raum-Position k;

Fig. 5    ein radiales Abtastmuster bestehend aus 20 Strahlen und seine Aufteilung in drei Zonen;

Fig. 6a    ein spirales k-Raum-Abtastmuster, bestehend aus einem Spiralelement mit exponentiell ansteigender Spiralenradiensteigung;

Fig. 6b    ein spirales k-Raum-Abtastmuster, bestehend aus zwei Spiraleiementen (E1 und E2), wobei beide Elemente um 180° verdreht sind und ansonsten dem in Fig. 6a gezeigten Element gleichen;

Fig. 6c    ein spirales k-Raum-Abtastmuster, bestehend aus einem Element und linear ansteigender Sprialenradiussteigung, wobei die Steigung stufenweise erhöht ist und die resultierenden Zonen, sowie die entsprechenden maximalen k-Raum-Punkteabstände ($\Delta k_i$) ebenfalls eingezeichnet sind;

Fig. 7a    ein eindimensionales k-Raum-Abtastmuster und die Extraktion von zwei Untermustern ($S_1$ & $S_2$), sowie schematisch die Rekonstruktion der Signaldichte ($FT_1$ & $FT_2$) aus den k-Raum-Signalen entsprechend der Untermuster $S_1$ und $S_2$;

Fig. 7b    die interpolierte Signaldichte $FT_1$ (A), die interpolierte und anschließend gefaltete Signaldichte $FT_1$ (B) und das extrahierte, isolierte Aliasing (C);

Fig. 7c    die Eliminierung des Aliasings aus der Signaldichte $FT_2$ durch Subtraktion;

Fig. 7d    die resultierende Signaldichte $FT_{new}$ aus $FT_1$ und korrigierter $FT_2$, sowie die abgewandelte Version $FT_{new}$ im Falle von weiteren Iterationsschritten;

Fig. 8a    die Verteilung der aufgenommenen k-Raum-Daten auf einem äquidistanten Gitter im Rahmen des Gewichtungsverfahren;

Fig. 8b    die $FOV_i$ spezifische Gewichtung des nun äquidistanten k-Raums und das Ergebnis nach anschließende Standard Fourier-Rekonstruktion(=FFT), wobei der jeweilige Teil des FOV, welcher artefaktfrei rekonstruiert wird, schraffiert dargestellt ist und der Linienabstand der globalen Auflösung entspricht (je dünner der Linienabstand, desto höher die globale Auflösung);

Fig. 8c    das zusammengesetzte, finale FOV aus Teilen der einzelnen $FOV_i$;

Fig. 9a    die resultierende MR-Aufnahme nach Anwendung des Standardverfahrens der globalen Auflösungserhöhung mit stark inhomogener Auflösung;

Fig. 9b    die auflösungshomogenisierte MR-Aufnahme nach Anwendung des Iterationsverfahrens;

Fig. 9c    die auflösungshomogenisierte MR-Aufnahme nach Anwendung des Gewichtungsverfahrens.

*Einführung*

Die vorliegende Erfindung betrifft eine Weiterentwicklung von Verfahren der bifdgebenden Magnetresonanz, welche nicht-lineare Gradienten zur Ortskodierung verwenden. Ein solches Verfahren ist zum Beispiel unter dem Namen PatLoc bekannt geworden, an welchem im Folgenden die Eigenschaften der nicht-linearen Ortskodierung exemplarisch erläutert werden.

in einer typischen Implementierung von PatLoc erfolgt die Ortskodierung entlang den beiden Dimensionen senkrecht zur Richtung des Hauptmagnetfeldes $B_0$ mittels quadrupolarer Gradientenfelder, wohingegen für die Kodierung entlang der Richtung des $B_0$ Feldes aus technischen Gründen weiterhin ein linearer Gradient Verwendung findet. Während gängige lineare Gradientensystem vor allem bei größeren abzubildenden Objekten bei bereits typischen Ortsauflösungen und Messzeiten zu erheblichen Magnetfeldunterschieden in den Randbereichen führen, können letztere durch die Verwendung angepasster, nicht-linearer Gradientensystem deutlich reduziert werden. Folglich sind auch die bei Schaltung der Gradienten aus der Wechselwirkung mit dem Hauptmagnetfeld $B_0$ resultierenden Lorentzkräfte geringer, was wiederum die mechanische Belastung im Tomographen und somit die Lärmbelastung, aber auch die aus den Wechselwirkungen resultierende Gefahr von neurologischen Stimulationen im Patienten reduziert. Mit solchen angepassten, nicht-linearen Gradientensystemen ist somit auch eine schnellere Schaltung der Gradienten möglich, was wiederum die Weiterentwicklung moderner und schnellerer MR-Bildgebungsverfahren erlaubt.

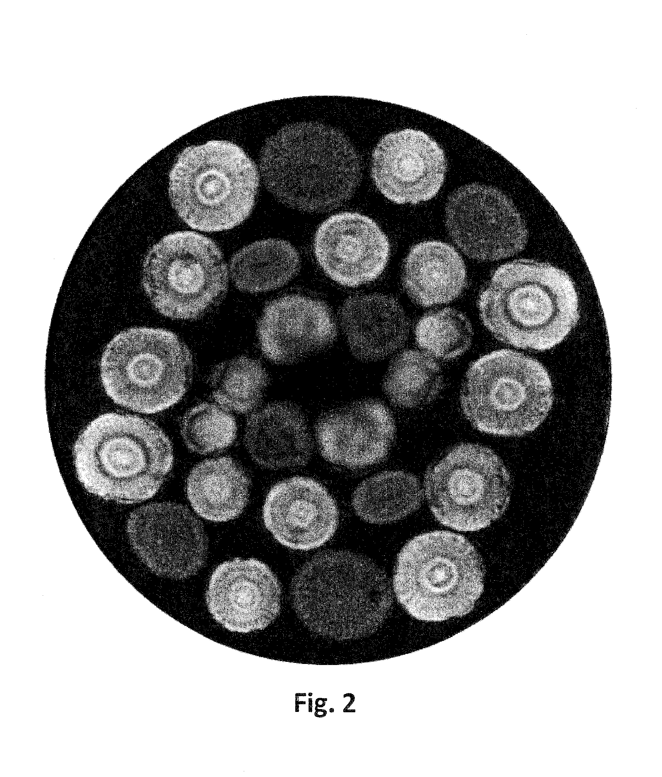

Allgemein hat die Verwendung nicht-linearer Gradienten zur Ortskodierung jedoch eine inhomogene Auflösung in den MR-Aufnahmen zur Folge. Dies erschwert die Interpretation der Aufnahmen erheblich und schränkt daher besonders in der medizinischen Diagnostik die Anwendbarkeit des Verfahrens stark ein. **Figur 2** zeigt eine MR-Aufnahme von einem organischen Objekt, aufgenommen mit einem quadrupolaren Gradientensystem entsprechend der obigen Beschreibung. Der Bereich mit dem flachsten Gradientenprofil und somit der geringsten Auflösung befindet sich in der Mitte des FOV. Während die Ränder des Sichtfeldes auf Grund des zum Rand hin stark ansteigenden Gradientenprofils besonders hoch aufgelöst werden, nimmt die Auflösung zur Mitte hin stetig ab. Auf Grund der wenigen und dementsprechend großen Voxels ist hier eine Darstellung des abzubildenden Objektes nicht mehr möglich, der Bereich erscheint als "Loch" in der MR-Aufnahme.

Bisher ist eine Erhöhung der Auflösung in den niedriger aufgelösten Bereichen und eine somit schrittweise Reduzierung des "Lochdurchmessers" nur durch das Standardverfahren einer zeitintensiven, globalen Anhebung der Auflösung in der gesamten MR-Aufnahme durch Erhöhung Matrixgröße möglich. Für den Fall einer standardmäßigen, kartesischen Abtastung des k-Raums, wie in **Figur 1a** gezeigt, ist die Ausdehnung des größten Voxels für ein quadrupolares Gradientenfeld entlang einer Dimension durch

$$(7)\quad \Delta x_{Mitte} = \frac{FOV}{\sqrt{N_x \times 2}}$$

gegeben, wobei $N_x$ die Anzahl der Matrixpunkte entlang der entsprechenden Dimension und FOV die Breite des Sichtfeldes bezeichnet. Bereits eine Halbierung des mittleren Voxels erfordert folglich eine Vervierfachung der Matrixgröße. Auch bei der Verwendung nicht-linearer Gradientensysteme setzt sich die Aufnahmedauer, wie in Gleichungen (5) und (6) beschrieben, aus der durch die Matrixgröße gegebenen Anzahl der Phasenkodierschritte und der Zeilenaufnahmedauer TR zusammen. Eine Verkleinerung der "Löcher" in den MR-Aufnahmen hat daher eine starke Erhöhung der Aufnahmedauer zur Folge. Dies schlägt sich insbesondere in der Aufnahmedauer von dreidimensionalen Kopfaufnahmen nieder, wo aus anatomischen Gründen die Lesekodierung entlang der Achse des $B_0$-Feldes erfolgt und somit beide nicht-lineare Gradienten für die Phasenkodierung verwendet werden müssen. Um in einer solchen dreidimensionalen Aufnahme die Ausdehnung des mittleren Voxels entlang beider Phasenkodierrichtungen halbieren zu können, ist eine 16-fache Matrixgröße erforderlich.

Das dem Stand der Technik entsprechende Verfahren der globalen Auflösungserhöhung zeichnet sich ebenfalls dadurch aus, das Teile der zusätzlichen Messzeit nur darauf verwendet werden, auch in den Bereichen mit steilerem Gradientenprofil, und demnach mit bereits ausreichend kleiner Voxelgröße, die Auflösung entgegen den Anforderungen weiter zu erhöhen. Dies wirkt nicht nur dem angestrebten Ziel einer Messzeitreduktion entgegen, auch ist in den Bereichen hoher Gradientenstärke, in denen das durch die Moleküldiffusion gegebene physikalische Auflösungslimit einer MR-Messung erreicht wird, gar kein Informationszugewinn mehr möglich. Aber auch bei niedriger aufgelösten Bereichen ist der zusätzliche Informationsgewinn bereits beschränkt, da sich kleinere Voxel durch ein geringeres Signal-zu-Rausch (= SNR) Verhältnis auszeichnen. Durch eine Erhöhung der Auflösung über die Anforderungen hinaus wird somit auch die Bildqualität verschlechtert.

*Erfindungsgemäßes Verfahren*

Das erfindungsgemäße Verfahren beruht auf dem Prinzip, die niedrigere Auflösung in den MR-Aufnahmen in den Bereichen schwächerer Gradienten gezielt an das Niveau des Auflösung in den bereits ausreichend aufgelöst dargestellten Bereichen anzupassen. Im Gegensatz zum Standardverfahren wird die Auflösung somit nicht global, sondern nur lokal erhöht. Folglich ist es auch möglich, die Größe von "Löchern" in den MR-Aufnahmen stark zu reduzieren und somit auch Strukturen in den Bereichen besonders schwacher Gradienten darzustellen. Die selektive Auflösungserhöhung führt demnach zu einer Homogenisierung der Auflösung in der gesamten MR-Aufnahme und vermeidet zusätzlich eine Verschlechterung der Bildqualität in den bereits ausreichend aufgelösten Bereichen durch Verhinderung einer weiteren Verkleinerung der Voxel. Sie führt somit zu einer entsprechend einfacheren Interpretierbarkeit der MR-Aufnahmen.

Ermöglicht wird diese selektive, lokale Auflösungserhöhung durch Ausnutzung der vorhandenen Korrelation zwischen der Position im k-Raum und der Position im Ortsraum. Hierbei handelt es sich um eine besonderes Merkmal bei der Verwendung nicht-lineare Gradienten zur Ortskodierung. Bei der sonst üblichen Verwendung von linearen Gradienten ist keine Korrelation zwischen Kodier- und Ortsraumposition vorhanden. Die beschriebene Korrelation hat zur Folge, dass die Aufnahme niederfrequenterer k-Raum-Signale durch Abtastung der k-Raum-Mitte mit hoher Dichte bereits ausreicht, das abzubildende Objekt in den Bereichen mit steilerem Gradientenprofil ausreichend aufgelöst darstellen zu können. Die Größe des Sichtfeldes ist auch hier für eine bestimmte Gradientenfeldgeometrie bedingt durch den Abstand der aufgenommenen k-Raum-Punkte ($\Delta k$). Die Aufnahme zusätzlicher, hochfrequenterer k-Raum-Punkte führt folglich zu einer Erhöhung der Bildauflösung, wie in Gleichung (4) beschrieben. Wird hierbei der Abstand der zusätzlichen k-Raum-Punkte erhöht, so tragen diese Punkte nur zur Erhöhung der Auflösung in einem entsprechend kleinerem Sichtfeld bei, die Auflösungserhöhung wird somit auf einen bestimmten Bereich begrenzt. Dieser Prozess ist vergleichbar mit einer Reduzierung des Sichtfeldes durch Erhöhung der k-Raum-Schrittweite. Durch gezielte Wahl der Position der zusätzlichen k-Raum-Punkte und entsprechender Ausrichtung des zugehörigen Sichtfeldes kann die damit verbundene Auflösungserhöhung auf die Bereiche mit schwächerem Gradientenprofil, und dementsprechend schlechterer Auflösung, begrenzt werden.

Das bisher beschriebene Verfahren kann in dieser Form auch auf konventionelle MR-Aufnahmen unter Verwendung linearer Gradienten zur Ortskodierung angewandt werden. Auch im Falle der Verwendung nicht-linearer Gradienten zur Ortskodierung hat eine Verkleinerung des Sichtfeldes bei Nichtabdeckung des zu untersuchenden Objektes Faltungsartefakte zur Folge. Im Unterschied zur Verwendung linearer Gradienten sind nun jedoch, auf Grund der vorliegenden Korrelation zwischen k-Raum und Ortsraum, die nach innen gefalteten Bildanteile bereits aus den niederfrequenteren k-Raum-Daten ausreichend genau bekannt, das heißt bereits entsprechend den Anforderungen aufgelöst. Eine adäquate Beschreibung der Faltungsanteile ist somit möglich, so dass die korrespondierenden Artefakte in den Bereichen mit gesteigerter Auflösung eliminiert werden können. Das Ergebnis ist ein Unterbereich im Gesamtsichtfeld, in welchem das abzubildende Objekt höher aufgelöst, aber auch artefaktfrei dargestellt wird. Im Falle linearer Gradienten ist dies auf Grund der fehlenden Korrelation zwischen Orts- und k-Raum nicht möglich.

Die gezielte Hinzunahme hochfrequenter k-Raum-Punkte zur lokalen Auflösungserhöhung kann prinzipiell in allen Dimensionen in denen ein nicht-linearer Gradient zur Ortskodierung verwendet wird, erfolgen. Im Falle der Anwendung auf zum Beispiel nur eine Dimension bei einer zweidimensionalen Aufnahme, werden entlang der anderen Dimension äquidistante k-Raum-Punkte entsprechend dem Standardverfahren hinzugenommen. Für das Standardverfahren empfiehlt sich hierbei die Leserichtung, da in dieser Dimension eine zusätzliche Aufnahme von k-Raum-Punkte ohne Messzeitverlängerung möglich ist. Im Fall einer zu starken Verschlechterung des SNR in den bereits ausreichend aufgelösten Bereichen, empfiehlt sich eine Zusammenlegung entsprechender Voxel.

Ein im Sinne des erfindungsgemäßen Verfahrens bevorzugtes k-Raum-Abtastmuster ist durch eine Überlagerung von $\ell$ kartesischen Untermustern gegeben. Jedes Untermuster besteht hierbei pro Dimension aus N äquidistanten k-Raum-Punkten. Die Dimensionalität des Untermusters, und somit auch des gesamten k-Raum-Abtastmusters, entspricht der Dimensionalität der Aufnahme. Ausgehend von dem Untermuster mit dem geringsten Punkteabstand ($n_i = 1$, $\Delta k_1 = \Delta k$) erhöht sich der Abstand für jedes weitere Untermuster gemäß

$$(8) \quad \Delta k_i = \alpha^{(i-1)} \times \Delta k \ .$$

Der k-Raum-Punkteabstand $\Delta k$ des engsten Untermusters wird hierbei durch die Größe des zugehörigen Sichtfeldes $FOV_1$ festgelegt. Dieses ist in der Regel an das abzubildende Objekt angepasst, um Faltungsartefakte zu vermeiden. Die Anzahl der Punkte N pro Untermuster und Dimension bestimmt die Auflösung innerhalb des $FOV_1$ und wird so gewählt, dass das abzubildende Objekt in den Bereichen mit steilem Gradientenprofil den Anforderungen entsprechend aufgelöst wird. So ergibt sich zum Beispiel für ein quadrupolares Gradientenfeld ein Gesamtsichtfeld $FOV_1$ von

$$(9) \quad FOV_1 = \sqrt{\frac{2}{\Delta k}} \ .$$

Die k-Raum-Punkte jedes weiteren Untermusters resultieren in einem Unterbereich des Gesamtsichtfeldes

FOV$_1$ mit einer Größe entsprechend dem Sichtfeld FOV$_i$, in welchem die Auflösung erhöht ist. Die Größe der einzelnen Unterbereiche FOV$_i$ ist für ebendieses Gradientenfeld gegeben durch

$$(10)\ \ FOV_i = \sqrt{\frac{2}{\Delta k_i}} = \sqrt{\frac{2}{\alpha^{(i-1)} \times \Delta k}} \ .$$

In jedem zusätzlichen Unterbereich ist die Auflösung gegenüber dem vorherigen Unterbereich um den Faktor $\dfrac{1}{\sqrt{\alpha}}$ erhöht. Der Parameter k mit

$$(11)\ \ \kappa(i) = \frac{FOV_i}{FOV_1} = \frac{1}{\sqrt{\alpha^{(i-1)}}}$$

beschreibt hierbei, wie weit die Auflösung im Unterbereich FOV$_i$ gegenüber der Auflösung im Gesamtsichtfeld FOV$_1$ gesteigert ist. Der variable Abstandsfaktor $\alpha$ ist hierbei an die Geometrie des abzubildenden Objektes und der Geometrie des Gradientenfeldes anzupassen und bestimmt die Schrittweite, mit welcher die Unterbereiche FOV$_i$ verkleinert werden. Im Falle von ungeraden Abstandsfaktoren $\alpha$, für welche die Punkte der Untermuster in den überlagerten Bereichen nicht oder nur teilweise zusammenfallen würden, können die entsprechenden k-Raum-Punkte auf Grund der höheren Abtastdichte der engeren Untermuster aus den bereits abgetasteten Punkten interpoliert werden und müssen somit nicht zusätzlich aufgenommen werden. **Figur 1d** zeigt das beschriebene k-Raum Abtastschema für zwei Dimensionen mit N = 8, $\ell$ = 3 und $\alpha$=2.

Der Anteil der insgesamt aufzunehmenden k-Raum-Punkte im Vergleich zum Standardverfahren der globalen Auflösungserhöhung ergibt sich zum Beispiel bei Anwendung des Verfahrens auf eine Dimension zu

$$(12)\ \ \frac{\#\,Punkte\ Iterationsverfahren}{\#\,Punkte\ Standardverfahren} = \frac{1+(\ell\text{-}1)\times 0.5}{2^{\ell\text{-}1}} \ .$$

Gemäß Gleichung (12) ergibt sich beispielsweise bei Verwendung von $\ell$ = 3 Untermustern im Vergleich zum Standardverfahren der globalen Auflösungserhöhung eine Reduzierung der insgesamt aufzunehmenden Datenpunkte M auf 50 %, bei $\ell$ = 4 sogar auf 31 % pro Dimension. Dies entspricht einer Zeitersparnis bei der Datenaufnahme von 50 %, beziehungsweise 69 %.

Das erfindungsgemäße Verfahren funktioniert ebenfalls mit einem k-Raum-Abtastmuster welches wiederum eine Überlagerung von $\ell$ kartesischen Untermustern darstellt, wobei jedoch die Anzahl der Punkte pro Dimension, N$_i$, der einzelnen Untermuster i variiert werden. Ausgehend von dem Untermuster mit dem geringsten Punktabstand (i = 1, $\Delta k_1$= $\Delta k$) verdoppelt sich der Abstand für jedes weiteres Untermuster gemäß

$$(13)\ \ \Delta k_i = 2^{(i-1)} \times \Delta k \ .$$

Der k-Raum-Punkteabstand $\Delta k$ des engsten Untermusters bestimmt wiederum die Größe des Gesamtsichtfeldes FOV$_1$. Für ein quadrupolares Gradientenfeld ist die Größe der Unterbereiche FOV$_i$ ebenfalls durch Gleichung (10) gegeben. Der Vergößerungsfaktor K(i) (Gleichung (14)) ist nun abhängig von der Anzahl der Punkte N$_i$ des jeweiligen Untermusters i, so dass eine individuelle Anpassung der Auflösungserhöhung innerhalb eines Unterbereiches gegenüber den angrenzenden Unterbereichen möglich ist.

$$(14)\quad \kappa(i) = \frac{FOV_i \times N_1}{FOV_1 \times N_i} = \frac{N_1}{N_i \times \sqrt{\alpha^{(i-1)}}}$$

Gemäß dem erfindungsgemäßen Verfahren ist auch ein k-Raum-Abtastmuster möglich, welches eine Überlagerung von $\ell$ kartesischen Untermustern darstellt, wobei nun zum Beispiel sowohl die Anzahl der Punkte pro Dimension der einzelnen Untermuster i ($N_i$), als auch der Punkteabstand der einzelnen Untermuster ($\Delta k_i$) über einen flexiblen Abstandsfaktor $\alpha_i$ variiert werden. Die Größe des Gesamtsichtfeldes wird auch hier wieder über den Punkteabstand des Untermusters mit geringstem Punkteabstand (i = 1) bestimmt, welches somit die höchste Abtastdichte aufweist. Die Größe des größten Voxels ergibt sich für die gegebene Gradientenfeldgeometrie aus der Anzahl und dem Abstand der Abtastpunkte des Untermusters mit größtem Punkteabstand (i = $\ell$), was der geringsten vorliegenden Abtastdichte $\rho_k$ entspricht. Durch die gleichzeitige Variation der Anzahl an Punkten pro Dimension der einzelnen Untermuster ($N_i$) und der flexiblen Änderung des Punkteabstands zwischen den Untermustern durch den Abstandsfaktor $\alpha_i$ ist eine hohe Flexibilität gegeben, so dass auch speziellere k-Raum-Abtastmustern aus kartesischen Untermustern mit einer besonders glatten und monotonen Änderung der Abtastdichte $\rho_k$ für steigenden Abstand von der Mitte des k-Raums approximiert werden können. Somit ist es möglich, gleichzeitig die Größe der Unterbereiche, als auch den Grad der Auflösungserhöhung in diesen, an die vorhandene Geometrie des Gradientenfeldes und des abzubildenden Objektes anzupassen.

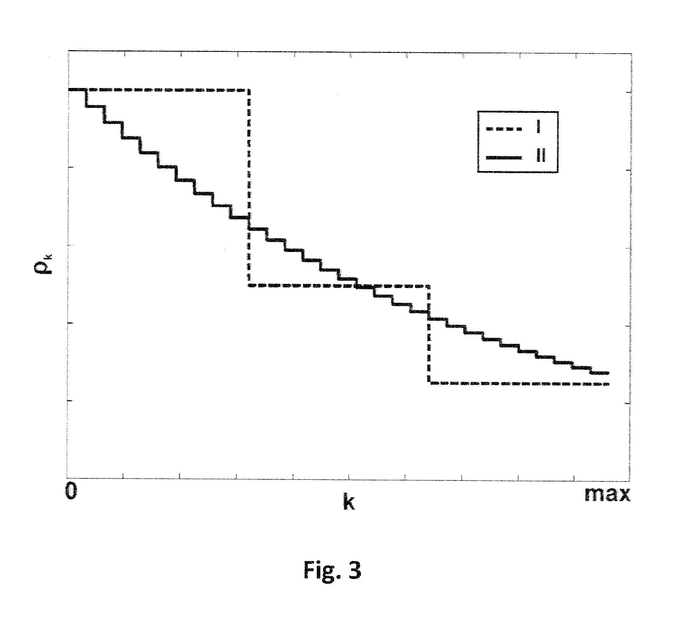

**Figur 3** zeigt exemplarisch eine mit ansteigender k-Raum-Position abfallend verlaufende Abtastdichte (Abtastdichte I), welche sich aus der Überlagerung von $\ell$ = 3 Untermustern mit jeweils verdoppelten Abtastabstand ($\alpha$ = 2, gemäß Gleichung (8)) und einer Änderung der Anzahl $N_i$ an Punkten pro Untermuster i gemäß

$$(15)\quad N_i = \frac{i \times N_1}{\alpha^{(i-1)}}$$

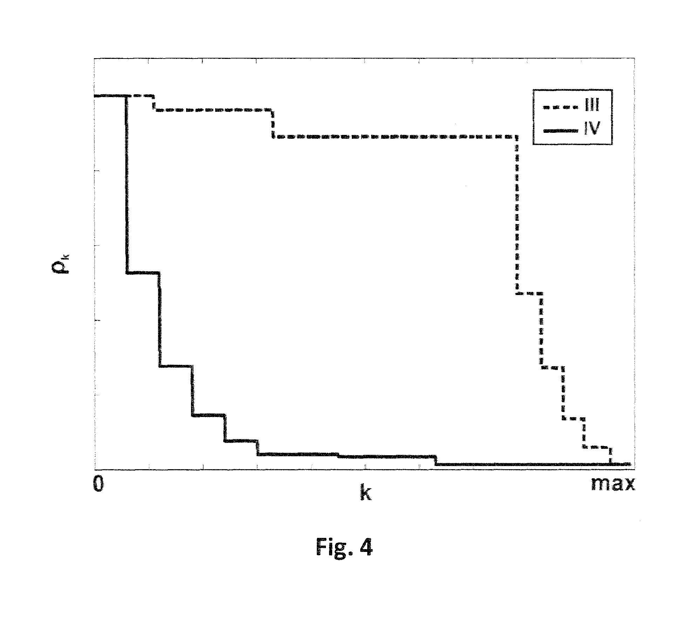

ergibt. Der stufenförmig abfallende Verlauf der Abtastdichte resultiert in der rekonstruierten MR-Aufnahme in drei Unterbereichen, in welchen die Auflösung stufenmäßig erhöht wird. Der ebenfalls gezeigte Verlauf der Abtastdichte II setzt sich hingegen aus $\ell$ = 30 Untermustern zusammen, wobei der Abtastabstand gemäß Gleichung (8) mit $\alpha$ = 1,045 vergrößert wird. Die Variation der Anzahl an Abtastpunkten pro Untermuster erfolgt hier ebenfalls analog Gleichung (15). Abtastdichte II deckt somit den gleichen k-Raum-Bereich ab, jedoch ist der Abfall des Verlaufs der Abtastdichte II gegenüber dem der Abtastdichte II deutlich glätter. Der in diesem Beispiel gewünschte exponentielle Abfall kann folglich viel besser approximiert werden. Die rekonstruierte MR-Aufnahme weißt somit das gleiche Gesamtsichtfeld auf, setzt sich nun jedoch aus 30 Unterbereichen zusammen, so dass eine möglichst glatte Auflösungserhöhung erzielt werden kann. **Figur 4** zeigt exemplarisch den Verlauf von zwei Abtastdichten für ein quadrupolares Gradientenfeld, welche durch Variation der Parameter $\alpha_i$ und $N_i$ erzeugt wurden. Der Verlauf der Abtastdichte III ist hierbei SNR optimiert, so dass große Bereiche des k-Raums mit hoher Dichte abgetastet werden. Der Verlauf der Abtastdichte IV ist dagegen bezüglich der Aufnahmegeschwindigkeit optimiert, lediglich die Mitte des k-Raums wird mit hoher Dichte abgetastet und in den übrigen Bereichen werden weniger Punkte aufgenommen. Das Gesamtsichtfeld der aus den, entsprechend dem Verlauf der beiden Abtastdichten aufgenommenen, k-Raum-Daten rekonstruierten Bilder ist gleich groß, da beide Abtastdichten die gleichen Startwerte aufweisen. Ebenfalls sind die jeweils größten Voxel gleich groß, da beide Abtastdichten dieselben Endwerte aufweisen.

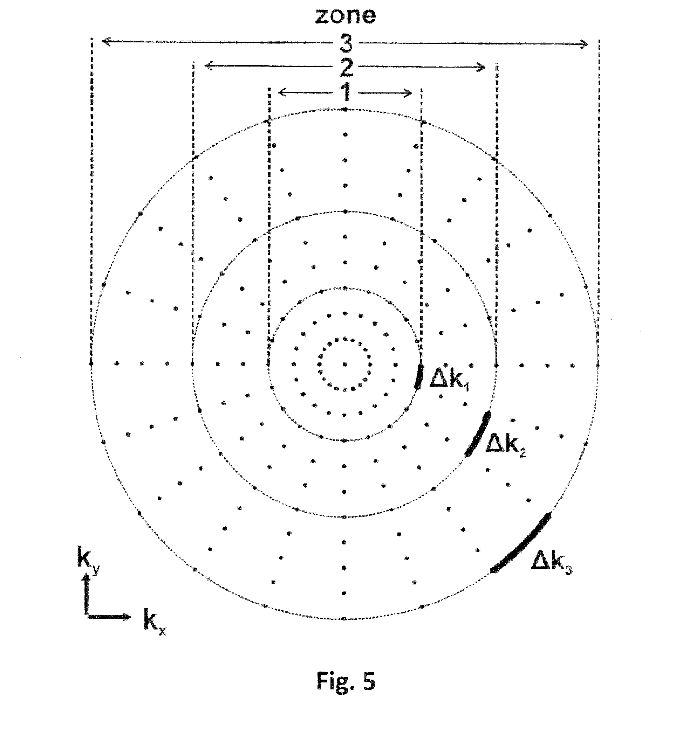

In **Figur 1b** ist ein radiales k-Raum-Abtastmuster [6] bestehend aus 18 Strahlen dargestellt. Die jeweils gegenüberliegenden Strahlen werden hierbei vorzugsweise durch Anlegen des Lesegradienten innerhalb eines TR aufgenommen. Die jeweilige Orientierung des Gradienten wird durch entsprechende Kombination mehrerer Gradientenfelder erzielt. Ein radiales k-Raum-Abtastmuster zeichnet sich durch eine mit dem Abstand zur k-Raum-Mitte naturgemäß besonders glatt und monoton abfallender Abtastdichte aus, welche über die Anzahl der abgetasteten k-Raum-Strahlen global skaliert werden kann. Es kann als eigenständiges Abtastmuster mit variabler Dichte behandelt werden dessen Unterabtastung automatisch in beiden Dimensionen des k-Raums erfolgt. Wie in **Figur 5** dargestellt, kann ein radiales Abtastmuster jedoch auch in $\ell$, sich überlagernde, Zonen aufgeteilt werden. Die abgetasteten Punkte innerhalb der Zonen können nun auf ein periodisches Gitter interpoliert werden und resultieren somit in $\ell$ kartesischen Untermustern. Auf Grund der zunehmenden Abtastdichte zur Zonenmitte hin ist hierbei eine Interpolation der k-Raum-Daten ohne besonderen Informationsverlust möglich. Die Schrittweite des jeweiligen Untermusters ist durch den maximal vorliegenden Punkteabstand $\Delta k_i$ der jeweils zugehörigen Zone gegeben. Die Größe des größten Voxels wird wiederum durch den maximalen Punkteabstand der äußersten Zone bestimmt.

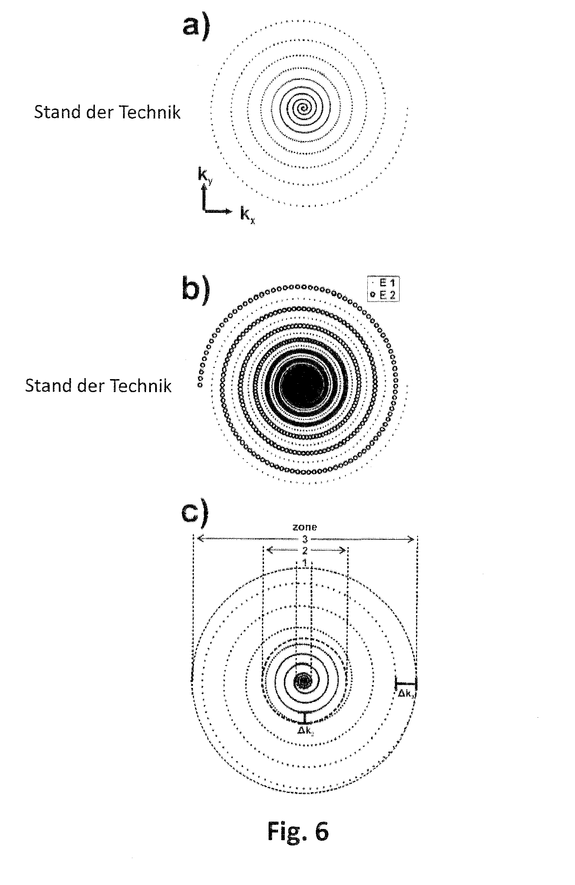

Ein weiteres bevorzugtes k-Raum-Abtastmuster stellt eine spiralförmigen Abtastung [6] des k-Raums dar, wobei das spirale k-Raum-Abtastmuster sich aus einem oder mehreren Spiralelementen zusammensetzt. Die Abtastdichte wird hierbei global über die Anzahl der Spiralelemente und lokal über die Variation der Spiralenradiensteigungen bestimmt. Durch diese hohe Flexibilität ist es, im Gegensatz zur radialen Abtastung, ebenfalls möglich, die Abtastdichte in der Mitte des k-Raumes und den Abfall der k-Raum-Abtastdichte gezielt zu ändern. Typischerweise wird entlang der Spirale der Lesegradient angelegt. So kann im Falle eines ausreichend langsamen Signalabfalls der k-Raum mittels weniger bis hin zu nur einer Anregung vollständig abgetastet werden. **Figur 6a** zeigt ein spiralförmiges k-Raum-Abtastmuster mit einer exponentiell ansteigenden Spiralenradiensteigung. Die Abtastdichte fällt entsprechend stark von der Mitte des k-Raums aus ab, die Unterabtastung erfolgt ebenfalls automatisch in beiden Dimensionen des k-Raums. Durch Hinzunahme einer zweiten, um 180° verdrehten Spirale (siehe **Figur 6b**), wird die Abtastdichte global verdoppelt. Analog zur radialen Abtastung, kann auch das spirale Abtastmuster als eine Überlagerung von Zonen aufgefasst werden. **Figur 6c** zeigt ein entsprechendes spirales Abtastmuster, bestehend aus drei Zonen. Die abgetasteten Punkte innerhalb der Zonen werden wiederum auf ein periodisches Gitter interpoliert und ergeben somit $\ell = 3$ kartesischen Untermustern. Die zugehörige Schrittweite ergibt sich jeweils aus dem maximalen Punkteabstand pro Zone.

Die Rekonstruktion der Bildintensität im Ortsraum aus den aufgenommenen k-Raum-Daten erfolgt bevorzugter Weise durch Berechnung der inversen Abbildungsmatrix $E^{-1}$ und anschließender Anwendung dieser auf die Signalintensität S im k-Raum gemäß

$$(16)\quad I_r = E^{-1} S .$$

Unter Voraussetzung der Verfügbarkeit der erforderlichen Rechnerleistung, können die MR-Aufnahmen somit direkt aus den k-Raum-Daten berechnet werden, die Bindung an äquidistante Gitter entfällt hierbei. Eine weitere Interpolation der k-Raum-Punkte ist demnach nicht notwendig, so dass eine entsprechende Verfälschung der k-Raum-Daten ausgeschlossen werden kann. Das Verfahren erlaubt somit auch die Verwendung maßgeschneiderter k-Raum-Abtastmuster, bei denen gezielt und effizient die notwendigen k-Raum-Punkte aufgenommen werden. Die resultierende Auflösung der MR-Aufnahme kann hierbei durch die Art des Rekonstruktionsprozesses stark bestimmt werden. Alternativ kann die direkte Rekonstruktion aus den k-Raum-Daten auch über die bekannte Methode der konjugierten Gradienten [7] erfolgen. Hierbei wird das Produkt $E^{-1}S$ aus der Abbildungsmatrix E und aufgenommenen Signalintensität im k-Raum iterativ angenähert. Vor allem bei größeren Datensätzen ist diese Methode der Methode der Matrixinversion zu bevorzugen, da hierbei signifikant weniger Rechnerleistung und Rechenzeit benötigt wird.

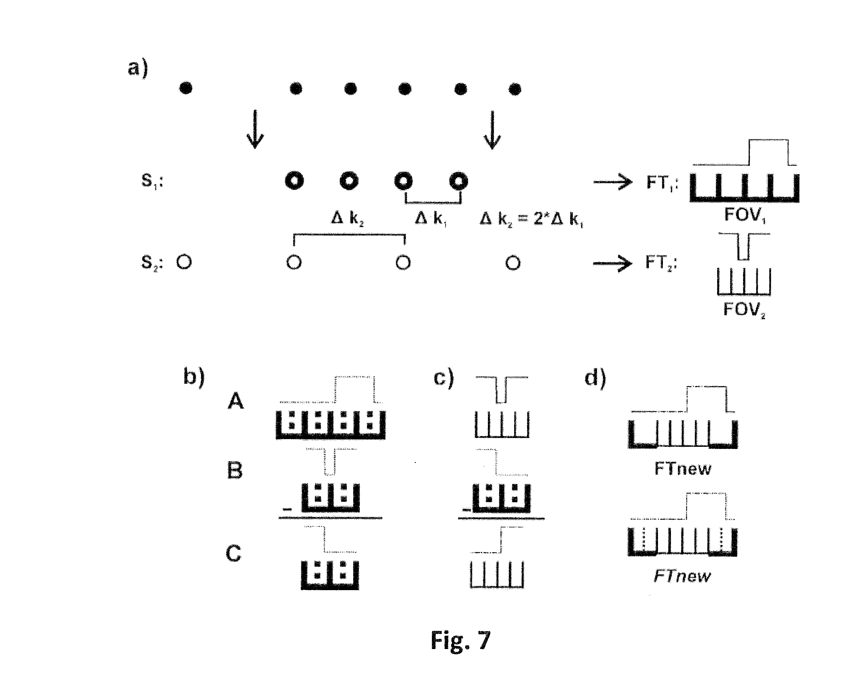

Die Rückführung der k-Raum-Abtastmuster auf äquidistante Untermuster erlaubt ebenfalls die Verwendung standardisierte, schneller Fourier-Methoden im Rahmen des erfindungsgemäßen Verfahrens. Das als Iterationsverfahren bezeichnete Rekonstruktionsschema ist in **Figur 7** exemplarisch für eine Dimension und einen Iterationsschritt dargestellt. Die aufgenommenen k-Raum-Daten erlauben die Extraktion von $\ell = 2$ Untermustern ($S_1$, $S_2$), welche sich jeweils aus N = 4 äquidistanten k-Raum-Punkten zusammensetzten. Das $FOV_1$ der via Fouriertransformation rekonstruierten Signaldichte $FT_1$ aus den k-Raum-Daten des Untermusters $S_1$ deckt hierbei das gesamte abzubildende Objekt ab. Innerhalb des kleineren $FOV_2$ ($FT_2$) ist das Objekt doppelt so hoch aufgelöst, die relative Größe der entsprechenden Voxel im Frequenzraum ist durch die eingezeichneten Kästen dargestellt. (siehe **Figur 7a**) Um nun den inneren Teil der rekonstruieren Signaldichte $FT_1$ durch die höher aufgelöste $FT_2$ ersetzten zu können, muss letztere für die von außerhalb des $FOV_2$ eingefalteten Anteile korrigiert werden. Hierfür wird die niedriger aufgelöste Signaldichte $FT_1$ auf die Auflösung der Signaldichte $FT_2$ interpoliert. Eine Kopie der interpolierten Signaldichte $FT_1$ wird zusätzlich gefaltet, um somit die Signaldichte $FT_2$ zu simulieren. Wie in **Figur 7b** dargestellt, ist es nun durch Subtraktion der beiden interpolierten Signaldichten möglich, den Faltungsanteil isoliert zu beschreiben. Die dadurch gewonnene Information erlaubt die Beseitigung des Aliasing aus der höher aufgelösten Signaldichte $FT_2$ (siehe **Figur 7c**). Die folglich nicht mehr gefaltete Signaldichte $FT_2$ bildet nun den inneren Teil der neuen Signaldichte $FT_{1new}$ (siehe **Figur 7d**). Wahlweise ist die Beschreibung der Faltung auch über das entsprechende Verhältnis zwischen den beiden interpolierten Signaldichten möglich. Werden k-Raum-Daten von mehr als zwei Untermustern verwendet, startet der iterative Prozess mit der Rekonstruktion des kleinsten FOV ($FT_{n-1}$ und $FT_n$), da mehrfach gefaltetes Aliasing rückwärts entfaltet werden muss. Hierbei wird die ebenfalls dargestellte Version $FT_{new}$ mit durchgehend gleicher Voxelgröße durch Verwendung der interpolierten Seitenteilen eingesetzt, um einen iterativen Prozess zu ermöglich. Auf Grund des niedrigeren Informationsgehalts der seitlichen Voxel im Frequenzraum hat dies keinen signifikanten Einfluss auf die Bildqualität. Nach Abschluss des iterativen Rekonstruktionsprozesses erfolgt einmalig die entsprechende Transformation aus dem Frequenzraum in den Bildraum.

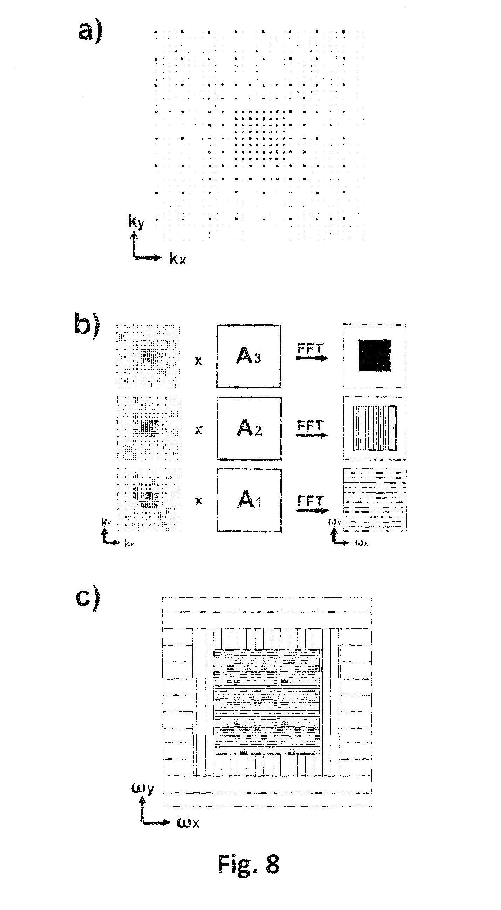

Ein alternatives erfindungsgemäßes Verfahren ist durch das Gewichtungsverfahren gegeben. Hierbei wird die auflösungshomogenisierte MR-Aufnahme ebenfalls aus den aufgenommenen k-Raum-Daten im Frequenzraum berechnet. Das zugehörige Rekonstruktionsverfahren ist in **Figur 8** für eine zweidimensionale MR-Aufnahme und einem k-Raum-Abtastmuster bestehend aus $\ell$ = 3 Untermuster illustriert. Die aufgenommenen k-Raum-Daten werden zuerst auf einem äquidistanten Gitter verteilt, wobei die nicht abgetasteten Stellen mit Nullen aufgefüllt werden. (siehe **Figur 8a**) Den k-Raum-Daten jedes Untermusters i lässt sich wiederum ein $FOV_i$ mit einer Größe gemäß Gleichung (10) zuordnen. Um eine faltungsfreie Signaldichte in diesem Bereich zu erhalten, wird eine Kopie des nun äquidistanten k-Raums entsprechend der Gewichtungsmatrix $A_i$ gewichtet, wobei die jeweilige Gewichtungsmatrix $A_i$ sich aus der mathematischen Beschreibung der im Rahmen des Iterationsverfahrens ausgeführten Prozesse unter zusätzlicher Einbeziehung der mit Nullen aufgefüllten k-Raum-Punkte ergibt. Anschließend erfolgt die Rekonstruktion mittels Fouriertransformation unter Verwendung aller k-Raum-Punkte. Hierbei wird automatisch die Signaldichte für einen Bereich gleich dem gesamten $FOV_1$ berechnet, jedoch kann nur der Bereich innerhalb des $FOV_i$ ohne Artefakte dargestellt werden. Der entsprechende Bereich ist in **Figur 8b** schraffiert. Dieser Vorgang wird für jedes $FOV_i$ wiederholt, wobei jeweils die passende Gewichtungsmatrix $A_i$ verwendet werden muss. Die Anzahl der $FOV_i$ entspricht der Anzahl an Untermustern $\ell$. Nach Abschluss der einzelnen Rekonstruktionen wird die nun auflösungshomogenisierte MR-Aufnahme aus den einzelnen $FOv_i$ wie in **Figur 8c** dargestellt zusammengesetzt. Anschließend erfolgt die Transformation aus dem Frequenzraum in den Ortsraum.

In einer weiteren Realisierung des erfindungsgemäßen Verfahrens wird innerhalb des Iterations-, aber auch innerhalb des Gewichtungsverfahren, die Eliminierung des Aliasing durch die zusätzliche Ortsinformation aus den Spulensensitivitätskarten unterstützt. Bei dem Gewichtungsverfahren findet hierbei die GRAPPA Rekonstruktionstechnik Anwendung. Nicht aufgenommene k-Raum-Punkte innerhalb der kartesisch abgetasteten Untermuster werden über Kalibrierungsfaktoren aus den aufgenommenen Punkten interpoliert. Die Berechnung der notwendigen Kalibrierungsfaktoren erfolgt hierbei aus den Sensitivitätsverteilungen der Spulen. Bei dem Iterationsverfahren kann an Stelle der GRAPPA Rekonstruktionstechnik auch die SENSE Rekonstruktionstechnik angewandt werden. Hierbei werden die aus den nicht aufgenommenen k-Raum-Punkten innerhalb der Untermuster resultierenden, zusätzlichen Faltungen innerhalb der rekonstruierten Signalintensitäten $FT_i$ mit Hilfe der zusätzlichen Ortsinformation aus den unterschiedlichen Empfangsspulen eliminiert. Durch die zusätzliche Einbeziehung der SENSE, beziehungsweise GRAPPA Rekonstruktionstechnik in das Iterations-, oder Gewichtungsverfahren können gezielt Punkte innerhalb der Untermuster ausgelassen werden. Die Aufnahmedauer wird dadurch reduziert. Des Weiteren erlaubt diese Weiterbildung, den Abtastabstand der einzelnen Untermuster auch mit Abstandsfaktoren größer als $\alpha_i$ = 2 zu variieren. Abstandfaktoren größer $\alpha_i$ = 2 resultieren allgemein in einer mehrfachen Faltungszunahme zwischen den Signalintensitäten ($FT_i$) aufeinanderfolgender Untermuster. Die somit, im Vergleich zu dem Im Rahmen des Iterationsverfahren beschriebenen Fall der einfachen Faltungszunahme, zusätzliche Faltung der Bilder kann mit Hilfe der Sensitivitätsverteilungen der Empfangsspulen analog dem SENSE Verfahren rückgefaltet werden. Für das Gewichtungsverfahren wird die Begrenzung der Abstandfaktoren auf Werte kleiner gleich $\alpha_i$ = 2 ebenfalls durch diese Weiterbildung aufgehoben. Hierfür wird jedoch die GRAPPA Rekonstruktionstechnik angewandt. Die Einbeziehung des SENSE, beziehungsweise GRAPPA Verfahrens, erlaubt demnach innerhalb der Rekonstruktionsmethode auch eine Reduzierung der Anzahl $\ell$ an Untermustern und somit eine weitere Verkürzung der Messzeit, da hierdurch noch weniger k-Raum-Punkte aufgenommen werden müssen.

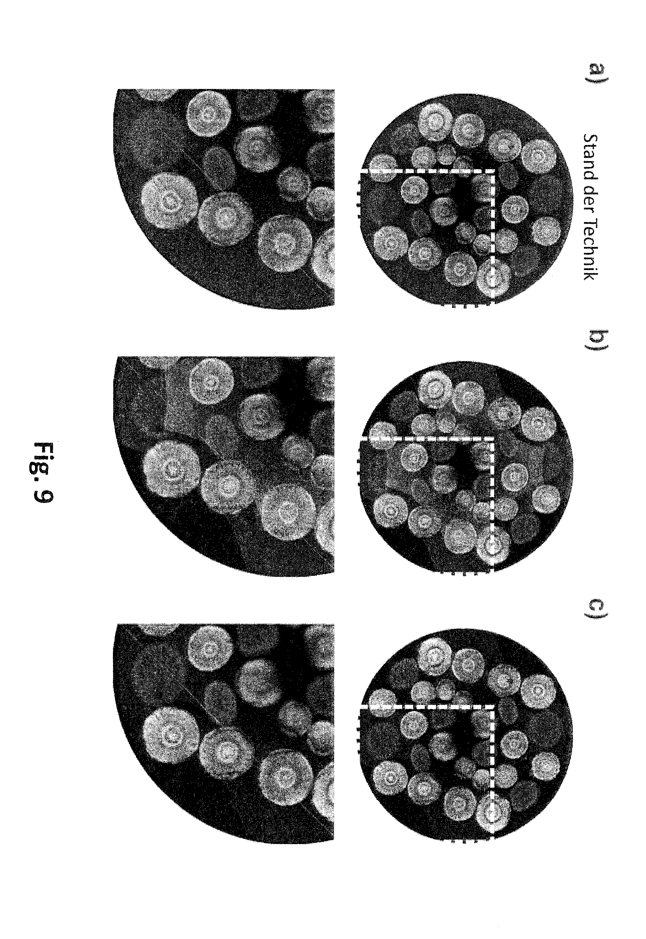

**Figur 9** zeigt je ein Ausführungsbeispiel für das beschriebene Iterations- und das Gewichtungsverfahren, sowie das Standardverfahren der globalen Auflösungserhöhung. MR-Datenaufnahme von einem organischen Objekt erfolgte auf einem Siemens 3T Tim Trio System, ausgestattet mit einem quadrupolaren Gradientensystem. (Sequenz: Gradienten-Echo, Matrix: 512 × 512, Sichtfeld 200 mm × 200 mm: Schichtdicke: 5 mm, TR/TE: 500/16 ms, FA: 50°, BW: 100 Hz). Analog dem in **Figur 1d** dargestellten Abtastungsschema wurden aus dem Demonstrationsdatensatz k-Raum-Daten mit $\ell$ = 3 Untermustern und N = 128 Abtastpunkten pro Dimension und Untermuster extrahiert. **Figur 9a** zeigt die Rekonstruktion unter Verwendung aller Punkte des Demonstrationsdatensatzes, welche dem Standardverfahren der globalen Auflösungserhöhung entspricht. Die räumlich stark inhomogene Auflösung ist deutlich zu erkennen. Zu den Randbereichen des FOV hin ist das erhöhte Rauschen deutlich sichtbar. Das Ergebnis nach Anwendung des Iterationsverfahrens ist in **Figur 9b** dargestellt. Auch in Bereichen mit zuvor geringerer Auflösung kann das abzubildende Objekt sehr gut dargestellt werden, die Auflösung ist deutlich homogener und das Rauschen in den Randbereichen ist gegenüber dem Ergebnis des Standardverfahrens deutlich niedriger. Auch nach mehreren Iterationsschritten weisen die nun höher aufgelösten Bildbereiche noch eine hohe Qualität auf. Das Ergebnis nach Anwendung des Gewichtungsverfahrens ist in **Figur 9c** gegeben. Die Auflösung ist ähnlich gut homogenisiert, zudem weißt die Abbildung eine besonders homogene SNR Verteilung auf. Die Übergänge zwischen den einzelnen $FOV_i$ sind daher kaum noch sichtbar.

Referenzen

**EP 2 378 308 A1**

[1] J. L. Duerk, "Principles of MR image formation and reconstruction," Magn Reson Imaging Clin N Am, vol. 7, pp. 629--659, Nov 1999.

[2] D. J. Larkman and R. G. Nunes, "Parallel magnetic resonance imaging," Phys Med Biol, vol. 52, pp. R15--R55, Apr 2007.

[3] K. P. Pruessmann, M. Weiger, M. B. Scheidegger, and P. Boesiger, "SENSE: sensitivity encoding for fast MRI," Magn Reson Med, vol. 42, pp. 952--962, Nov 1999.

[4] M. A. Griswold, P. M. Jakob, R. M. Heidemann, M. Nittka, V. Jellus, J. Wang, B. Kiefer, and A. Haase, "Generalized autocalibrating partially parallel acquisitions (GRAPPA)," Magn Reson Med, vol. 47, pp. 1202-1210, Jun 2002.

[5] J. Hennig, A. M. Welz, G. Schultz, J. Korvink, Z. Liu, O. Speck, and M. Zaitsev, "Parallel imaging in non-bijective, curvilinear magnetic field gradients: a concept study," MAGMA, vol. 21, pp. 5--14, Mar 2008.

[6] M. A. Bernstein, K. F. King, and X. J. Zhou, Handbook of MRI Pulse Sequences: Elsevier, 2004.

[7] T. Grotz, B. Zahneisen, A. Ella, M. Zaitsev, and J. Hennig, "Fast functional brain imaging using constrained reconstruction based on regularization using arbitrary projections," Magn Reson Med, vol. 62, pp. 394--405, Aug 2009.

**Patentansprüche**

1. Verfahren der bildgebenden Magnetresonanz (=MR), wobei zur Aufnahme von Bildern eines abzubildenden Objekts zum Zwecke der mindestens zweidimensionalen Ortskodierung nicht-lineare Gradientenfelder angelegt werden und wobei das von dem abzubildenden Objekt ausgestrahlte Magnetresonanzsignal auf Rastern im k-Raum abgetastet wird, wodurch Abtastpunkte erhalten werden,
**dadurch gekennzeichnet,**
**dass** das abzubildende Objekt in Bereichen stärkerer Gradientenfelder durch Erhöhung der Dichte der Abtastpunkte in der Mitte des k-Raums ausreichend genau abgebildet wird,
**dass** abhängig von der gewünschten Verteilung der Auflösung in der Aufnahme gezielt gemäß einem k-Raum-Abtastmuster zusätzliche Abtastpunkte in den äußeren Bereichen des k-Raums aufgenommen werden, und
**dass** die MR-Aufnahme mit den zusätzlichen Abtastpunkten berechnet wird.

2. Verfahren nach Anspruch 1, **dadurch gekennzeichnet, dass** sich das k-Raum-Abtastmuster aus Untermustern zusammensetzt, wobei jedes Untermuster aus der gleichen Anzahl von Abtastpunkten besteht, wobei für jedes Untermuster die Schrittweite zwischen den Abtastpunkten mit einem flexiblen Faktor gemäß den Anforderungen an die Homogenität der Auflösung der MR-Aufnahme und an die Signal-zu-Rausch(=SNR)-Verteilung in der Aufnahme erhöht wird.

3. Verfahren nach Anspruch 1, **dadurch gekennzeichnet, dass** sich das k-Raum-Abtastmuster aus Untermustern zusammensetzt, wobei für jedes Untermuster die Schrittweite zwischen den Abtastpunkten verdoppelt wird und die Anzahl an Abtastpunkten pro Untermuster gemäß den Anforderungen an die Homogenität der Auflösung der MR-Aufnahme und an die SNR-Verteilung in der Aufnahme variiert wird.

4. Verfahren nach Anspruch 2 und 3, **dadurch gekennzeichnet, dass** sich das k-Raum-Abtastmuster aus Untermustern zusammensetzt, wobei für jedes Untermuster die Schrittweite zwischen den Abtastpunkten mit einem flexiblen Faktor gemäß den Anforderungen an die Homogenität der Auflösung der MR-Aufnahme und an die SNR-Verteilung in der Aufnahme geändert wird, sowie die Anzahl an Abtastpunkten pro Untermuster gemäß den Anforderungen an die Homogenität der Auflösung der MR-Aufnahme und an die SNR-Verteilung in der Aufnahme variiert wird, wobei für die gegebene Gradientenfeldgeometrie die Schrittweite des Untermusters mit kleinstem Punkteabstand die Größe des Gesamtsichtfeldes bestimmt, und wobei für die gegebene Gradientenfeldgeometrie die Schrittweite und die Anzahl der Abtastpunkte des Untermusters mit dem größten Punkteabstand die Größe des größten Voxels bestimmen.

5. Verfahren nach Anspruch 1, **dadurch gekennzeichnet, dass** das k-Raum-Abtastmuster einer radialen Abtastung des k-Raumes entspricht, wobei die Abtastdichte mit dem Abstand zur k-Raummitte glatt und monoton abfällt, wobei die absolute Abtastdichte global über die Anzahl der abgetasteten k-Raumstrahlen skaliert wird, wobei für die gegebene Gradientenfeldgeometrie die Größe des größten Voxels durch die Länge der k-Raumstrahlen und durch den maximalen Abstand der k-Raumstrahlen am Rande des abgetasteten k-Raumes bestimmt wird.

6. Verfahren nach Anspruch 1, **dadurch gekennzeichnet, dass** das k-Raum-Abtastmuster einer spiralförmigen Abtastung des k-Raumes entspricht, wobei die Spirale aus einem oder mehreren Elementen besteht, wobei die absolute Abtastdichte global über die Anzahl der Spiralelemente und lokal über die Änderung der Spiralenradiensteigung variiert wird, wobei für die gegebenen Gradientenfeldgeometrie der maximale radiale Punkteabstand im Bereich der Mitte des k-Raumes die Größe des Gesamtsichtfeldes bestimmt, wobei für die gegebene Gradientenfeldgeometrie die maximale Entfernung der Abtastpunkte von der Mitte des k-Raumes und der maximale radiale Punkteabstand im Randbereich des abgetasteten k-Raumes die Größe des größten Voxels bestimmen.

7. Verfahren nach einem der vorhergehenden Ansprüche, **dadurch gekennzeichnet, dass** die Datenaufnahme mit einem Array bestehend aus mehreren Empfangsspulen erfolgt, wobei die räumliche Information, welche in der unterschiedlichen Sensitivitätsverteilung der Empfangsspulen enthalten ist, verwendet wird, um die Unterabtastung des k-Raums zu erhöhen.

8. Verfahren nach einem der Ansprüche 1 bis 7, **dadurch gekennzeichnet, dass** die Rekonstruktion der Signaldichte des darzustellenden Objektes durch Inversion der Kodiermatrix aus den aufgenommenen Daten erfolgt.

9. Verfahren nach einem der Ansprüche 1 bis 7, **dadurch gekennzeichnet, dass** die Signaldichfie des darzustellenden Objektes iterativ mit der Methode der konjugierten Gradienten über das Produkt aus der inversen Kodiermatrix und der Signalintensität im k-Raum angenähert wird.

10. Verfahren nach einem der Ansprüche 1 bis 7, **dadurch gekennzeichnet, dass** die k-Raumpunkte entsprechend den jeweiligen Untermustern getrennt mit schnellen, standardisierten Fourier-Methoden rekonstruiert werden und die auflösungshomogenisierte MR-Aufnahme aus den Einzelbildern der Untermuster iterativ berechnet wird.

11. Verfahren nach einem der Ansprüche 1 bis 7, **dadurch gekennzeichnet, dass** die auflösungshomogenisierte MR-Aufnahme aus Unterbildern zusammengesetzt wird, wobei die Unterbilder unter Verwendung von standardisierten Fourier-Methoden aus allen aufgenommenen Datenpunkten rekonstruiert werden, wobei diese hierfür auf ein äquidistantes Gitter verteilt werden und mit für das jeweilige Untermuster spezifischen Gewichtungsfaktoren gewichtet werden.

12. Verfahren nach den Ansprüchen 7, 10 und 11, **dadurch gekennzeichnet, dass** die auflösungshomogenisierte MR-Aufnahme unter Einbeziehung der unterschiedlichen Sensitivitätsverteilungen der Empfangsspulen aus den unterabgetasteten k-Raumsignalen der unterschiedlichen Empfangsspulen berechnet wird, wobei nur jeder R-te k-Raumpunkt der k-Raum-Abtastmuster aufgenommen wird, wobei $R \leq$ der Anzahl der verwendeten Empfangsspulen ist, wobei die Unterabtastung zur einer Reduktion der Aufnahmezeit und/oder globalen Erhöhung der Auflösung verwendet wird.

Stand der Technik

a)

Stand der Technik

b)

$k_y$

$k_x$

Stand der Technik

c)

d)

Fig. 1

Fig. 2

Fig. 3

Fig. 4

Fig. 5

a)

Stand der Technik

b)

Stand der Technik

c)

## Fig. 6

a)

$S_1$:

$\Delta k_2$  $\Delta k_1$  $\Delta k_2 = 2 * \Delta k_1$

$S_2$:

FT$_1$:

FOV$_1$

FT$_2$:

FOV$_2$

b) A
B
C

c)

d)
FTnew

FTnew

**Fig. 7**

Fig. 8

Europäisches
Patentamt

European
Patent Office

Office européen
des brevets

# EUROPÄISCHER RECHERCHENBERICHT

**Nummer der Anmeldung**

EP 11 16 0414

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X,P | H.WEBER ET AL.: "A time-efficient sub-sampling strategy to homogenise resolution in PatLoc imaging", PROC.INTL.SOC.MAG.RESON.MED., 1. Mai 2010 (2010-05-01), XP002641947, * das ganze Dokument * ----- | 1,3,7,8, 10,12 | INV. G01R33/54 |
| X | JUERGEN HENNIG ET AL: "Parallel imaging in non-bijective, curvilinear magnetic field gradients: a concept study", MAGNETIC RESONANCE MATERIALS IN PHYSICS, BIOLOGY AND MEDICINE, CHAPMAN AND HALL, LONDON, GB, Bd. 21, Nr. 1-2, 26. Februar 2008 (2008-02-26), Seiten 5-14, XP019596833, ISSN: 1352-8661 * das ganze Dokument * ----- | 1-9,12 | |
| A | TSAI C-M ET AL: "Reduced aliasing artifacts using variable-density k-space sampling trajectories", MAGNETIC RESONANCE IN MEDICINE, ACADEMIC PRESS, DULUTH, MN, US, Bd. 43, Nr. 3, 1. März 2000 (2000-03-01), Seiten 452-458, XP002179553, ISSN: 0740-3194, DOI: DOI:10.1002/(SICI)1522-2594(200003)43:3<452::AID-MRM18>3.0.CO;2-B * das ganze Dokument * ----- | 1-6,8 | **RECHERCHIERTE SACHGEBIETE (IPC)** G01R |

Der vorliegende Recherchenbericht wurde für alle Patentansprüche erstellt

| Recherchenort | Abschlußdatum der Recherche | Prüfer |
|---|---|---|
| München | 15. Juni 2011 | Lersch, Wilhelm |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

........................................................

& : Mitglied der gleichen Patentfamilie, übereinstimmendes Dokument

EPO FORM 1503 03.82 (P04C03)

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102007054744 B4
- DE 102005051021 A1
- US 6326786 B1
- DE 10126078 B4

**In der Beschreibung aufgeführte Nicht-Patentliteratur**

- **J. L. DUERK.** Principles of MR image formation and reconstruction. *Magn Reson Imaging Clin N Am,* November 1999, vol. 7, 629-659
- **D. J. LARKMAN ; R. G. NUNES.** Parallel magnetic resonance imaging. *Phys Med Biol,* April 2007, vol. 52, R15-R55
- **K. P. PRUESSMANN ; M. WEIGER ; M. B. SCHEIDEGGER ; P. BOESIGER.** SENSE: sensitivity encoding for fast MRI. *Magn Reson Med,* November 1999, vol. 42, 952-962
- **M. A. GRISWOLD ; P. M. JAKOB ; R. M. HEIDEMANN ; M. NITTKA ; V. JELLUS ; J. WANG ; B. KIEFER ; A. HAASE.** Generalized auto-calibrating partially parallel acquisitions (GRAPPA. *Magn Reson Med,* Juni 2002, vol. 47, 1202-1210
- **J. HENNIG ; A. M. WELZ ; G. SCHULTZ ; J. KORVINK ; Z. LIU ; O. SPECK ; M. ZAITSEV.** Parallel imaging in non-bijective, curvilinear magnetic field gradients: a concept study. *MAGMA,* Marz 2008, vol. 21, 5-14
- **M. A. BERNSTEIN ; K. F. KING ; X. J. ZHOU.** Handbook of MRI Pulse Sequences. Elsevier, 2004
- **T. GROTZ ; B. ZAHNEISEN ; A. ELLA ; M. ZAITSEV ; J. HENNIG.** Fast functional brain imaging using constrained reconstruction based on regularization using arbitrary projections. *Magn Reson Med,* August 2009, vol. 62, 394-405